# EUROPEAN PATENT APPLICATION

(11) **EP 4 708 297 A1**
(43) Date of publication of application: **11.03.2026**
(21) Application number: 25196066.2
(22) Date of filing: 14.08.2025
(51) Int. Cl.: G11C 16/08, G11C 16/24, G11C 16/26, G11C 16/32, G11C 16/34, G11C 11/56, G11C 16/30

(54) **NON-VOLATILE MEMORY DEVICE AND OPERATING METHOD THEREOF**

(30) Priority: 10.09.2024 KR 20240123425
(71) Applicant: Samsung Electronics Co., Ltd., Suwon-si, Gyeonggi-do 16677 (KR)
(72) Inventor: CHOI, Yonghyuk, 16677 Suwon-si (KR); CHOI, Kwangho, 16677 Suwon-si (KR)
(74) Representative: Marks & Clerk LLP

(57) **Abstract**

Provided are a non-volatile memory device and an operating method thereof. The non-volatile memory device includes a memory cell array comprising a plurality of memory cells connected to a plurality of wordlines and a plurality of bitlines, a page buffer unit comprising page buffers connected to the plurality of memory cells through the plurality of bitlines, and a control logic circuit configured to output at least one control signal to the page buffer unit for performing a read operation based on a read command and an address, the read operation comprising a wordline setup operation, a pre-charge operation, a develop operation, and a sensing operation. The control logic circuit is configured to detect a wordline charging current, adjust at least one of a bitline voltage control signal set after the wordline setup operation and a bitline connection control signal during the develop operation.

## Description

### BACKGROUND

Example embodiments of the inventive concepts relate to an electronic device, and more particularly, to a non-volatile memory device and an operating method thereof.

Memory devices are used to store data and may be divided into volatile memory devices and non-volatile memory devices. With the development of semiconductor manufacturing technology, the operating speed of a host device is continuing to improve and the capacity of content used in the host device is continually increasing. Therefore, it may be advantageous to improve the reliability of data stored in a memory device.

### SUMMARY

Some example embodiments of the inventive concepts provide a non-volatile memory device for improving the reliability of data and an operating method thereof.

According to some example embodiments of the inventive concepts, there is provided a non-volatile memory device including a memory cell array comprising a plurality of memory cells connected to a plurality of wordlines and a plurality of bitlines, a page buffer unit comprising page buffers connected to the plurality of memory cells through the plurality of bitlines, and a control logic circuit configured to output at least one control signal to the page buffer unit for performing a read operation based on a read command and an address, the read operation comprising a wordline setup operation, a pre-charge operation, a develop operation, and a sensing operation. The control logic circuit is configured to detect a wordline charging current that varies based on states of the plurality of memory cells, during a preset detection time in the wordline setup operation, and based on a detection value of the wordline charging current and at least one reference value, adjust at least one of a bitline voltage control signal set after the wordline setup operation and a bitline connection control signal during the develop operation.

According to some example embodiments of the inventive concepts, there is provided a non-volatile memory device including a memory cell array comprising a plurality of memory cells connected to a plurality of wordlines and a plurality of bitlines, a page buffer unit comprising page buffers connected to the plurality of memory cells through the plurality of bitlines; and a control logic circuit configured to output at least one control signal to the page buffer unit for performing a program verify operation in each of a plurality of program loops based on a write command and an address. The program verify operation comprises a wordline setup operation, at least one pre-charge operation, at least one develop operation, and at least one sensing operation, and the control logic circuit is configured to detect a wordline charging current that varies based on states of the plurality of memory cells during a preset detection time in the wordline setup operation, and perform, based on a detection value of the wordline charging current and at least one reference value, at least one of adjusting a bitline voltage control signal set after the wordline setup operation, and adjusting a bitline connection control signal during the at least one develop operation.

According to some example embodiments of the inventive concepts, there is provided an operating method of a non-volatile memory device including detecting a wordline charging current related to a plurality of wordline voltages, during a detection time equal to or less than a wordline setup period based on voltage levels of a plurality of wordlines increasing to voltage levels of the plurality of wordline voltages, determining an adjustment value for adjusting at least one of a bitline voltage control signal set and a bitline connection control signal applied to a plurality of bitlines based on a detection value of the wordline charging current and at least one reference value, activating the bitline voltage control signal set and a bitline setup signal, activating the bitline connection control signal after the bitline setup signal is deactivated, and activating at least one monitoring signal after the bitline connection control signal is deactivated.

According to some example embodiments of the inventive concepts, the reliability of data stored in the non-volatile memory may be improved.

At least some of the above and other features of the invention are set out in the claims.

### BRIEF DESCRIPTION OF THE DRAWINGS

Example embodiments will be more clearly understood from the following detailed description taken in conjunction with the accompanying drawings in which:
FIG. 1 is a block diagram of a storage system according to some example embodiments;
FIG. 2 is a block diagram of a non-volatile memory device according to some example embodiments;
FIG. 3 is a perspective view of a memory block according to some example embodiments;
FIG. 4 is a perspective view of a memory block according to some example embodiments;
FIG. 5 is a circuit diagram of a memory block according to some example embodiments;
FIG. 6 is a diagram illustrating a main block according to some example embodiments of the inventive concepts;
FIGS. 7A, 7B, 7C, and 7D are diagrams illustrating sub-blocks according to some example embodiments of the inventive concepts;
FIGS. 8A, 8B, 8C, and 8D are diagrams illustrating embodiments in which a wordline charging current according to some example embodiments are detected;
FIG. 9 is a block diagram of a control logic circuit according to some example embodiments;
FIG. 10 is a diagram illustrating a page buffer according to some example embodiments;
FIG. 11 is a timing diagram of signals provided to the page buffer of FIG. 10;
FIGS. 12A, 12B, 12C, 12D, and 12E are timing diagrams of current detection signals according to some example embodiments;
FIGS. 13A, 13B, and 13C are timing diagrams of control signals when a first current of FIG. 12A is detected;
FIGS. 14A, 14B, and 14C are timing diagrams of control signals when a fifth current of FIG. 12E is detected;
FIG. 15 is a diagram illustrating a plurality of program loops according to some example embodiments;
FIG. 16 is a diagram illustrating a page buffer according to some example embodiments;
FIG. 17 is a timing diagram of signals provided to the page buffer of FIG. 16;
FIG. 18 is a flowchart for describing an operation of detecting a wordline charging current in a program loop, according to some example embodiments;
FIG. 19 is a flowchart for describing an operation of detecting a wordline charging current, according to some example embodiments;
FIG. 20 is a flowchart illustrating an operating method of a non-volatile memory device, according to some example embodiments; and
FIG. 21 is a cross-sectional view illustrating a non-volatile memory device according to some example embodiments.

### DETAILED DESCRIPTION

Hereinafter, some example embodiments of the inventive concepts will be described in detail with reference to the accompanied drawings.

The expressions "first", "second", etc. used herein may describe various components, regardless of order and/or importance, and are only used to distinguish one component from another, and do not limit the components. For example, a first user device and a second user device may indicate different user devices, regardless of order or importance. For example, a first component may be named a second component, and similarly, the second component may also be renamed as the first component without departing from the scope of the rights described herein.

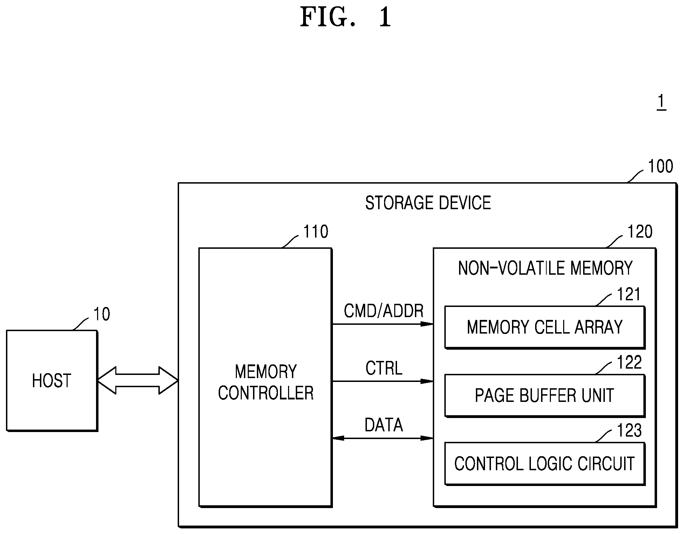

FIG. 1 is a block diagram of a storage system 1 according to some example embodiments.

Referring to FIG. 1, the storage system 1 may include a host 10 and a storage device 100.

The host 10 may communicate with the storage device 100 through an interface. Here, the interface may be implemented as, for example, Non-Volatile Memory Express (NVMe), NVMe Management Interface (MI), or NVMe Over Fabric (NVMeof). The host 10 may provide a write request, a logical address, and data to the storage device 100. The host 10 may provide a read request and a logical address to the storage device 100.

The storage device 100 may include a memory controller 110 and a non-volatile memory 120. The memory controller 110 and the non-volatile memory 120 may be integrated into one semiconductor device.

The memory controller 110 may control the non-volatile memory 120 to read data stored in the non-volatile memory 120 in response to a request (e.g., a write request or a read request) provided from the host 10 or write (or program) data in the non-volatile memory 120. Specifically, the memory controller 110 may provide a command/address CMD/ADDR and/or a control signal CTRL to the non-volatile memory 120, thereby controlling a write operation (or program operation), a read operation, and an erase operation on the non-volatile memory 120. In addition, data to be written DATA or read data DATA may be transmitted and received between the memory controller 110 and the non-volatile memory 120.

In some example embodiments, the memory controller 110 may provide a read command and a physical address to the non-volatile memory 120. The read command may be a command instructing to read data stored in memory cells (e.g., a page) connected to a selected wordline among a plurality of wordlines.

In some example embodiments, the memory controller 110 may provide a write command and a physical address to the non-volatile memory 120. The write command may be a command instructing to store data in memory cells connected to a selected wordline from among the plurality of wordlines.

The memory controller 110 may control a series of internal operations (e.g., performance control, merge, wear leveling, etc.) utilized for the characteristics of the non-volatile memory 120 or for more efficient management of the non-volatile memory 120.

In some example embodiments, the non-volatile memory 120 may include a memory cell array 121, a page buffer unit 122, and a control logic circuit 123.

The memory cell array 121 may include a plurality of memory blocks. Each memory block may include a plurality of memory cells. The plurality of memory cells may be connected to a plurality of wordlines and a plurality of bitlines.

The page buffer unit 122 may be connected to the plurality of memory blocks through a plurality of bitlines. For example, the page buffer unit 122 may include page buffers connected to the plurality of memory cells through a plurality of bitlines.

In some example embodiments, the control logic circuit 123 may output at least one control signal for performing a read operation to the page buffer unit 122 based on a read command and an address. The read operation may include a wordline setup operation, a pre-charge operation, a develop operation, and a sensing operation.

In some example embodiments, the control logic circuit 123 may control the page buffer unit 122 to perform a program operation based on a write command and an address. The program operation may include a plurality of program loops. One program loop may include a program execution operation and a program verify operation. The program verify operation may be similar to the read operation. For example, the control logic circuit 123 may output, to the page buffer unit 122, at least one control signal for performing the program verify operation in each of the plurality of program loops.

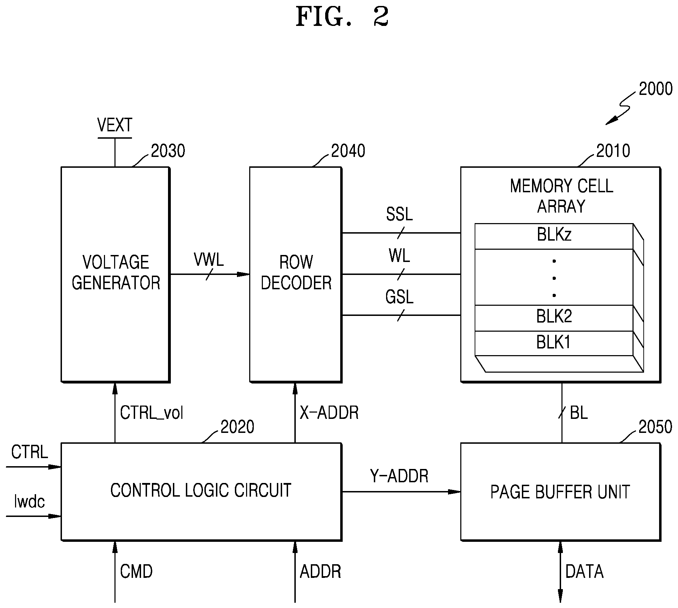

FIG. 2 is a block diagram of a non-volatile memory device 2000 according to some example embodiments.

Referring to FIG. 2, the non-volatile memory device 2000 may correspond to the non-volatile memory 120 of FIG. 1. The non-volatile memory device 2000 may include a memory cell array 2010, a control logic circuit 2020, a voltage generator 2030, a row decoder 2040, and a page buffer unit 2050. In some example embodiments, the non-volatile memory device 2000 may further include a data input/output circuit or an input/output interface.

The memory cell array 2010 may include a plurality of memory cells, and may be connected to wordlines WL, string selection lines SSL, ground selection lines GSL, and a plurality of bitlines BL. For example, the memory cell array 2010 may be connected to the row decoder 2040 through the wordlines WL, the string selection lines SSL, and the ground selection lines GSL, and may be connected to the page buffer unit 2050 through the plurality of bitlines BL.

The memory cell array 2010 may include a plurality of memory blocks BLK1 to BLKz. For example, each of a plurality of memory blocks BLK1 to BLKz may have a three-dimensional (3D) structure (or a vertical structure). Specifically, each of the plurality of memory blocks BLK1 to BLKz includes structures extending in first to third directions. For example, each of the plurality of memory blocks BLK1 to BLKz includes a plurality of NAND strings extending in the third direction. In this regard, a plurality of NAND strings may be spaced apart by a specific distance in the first and second directions. The plurality of memory blocks BLK1 to BLKz may be selected by the row decoder 2040. For example, the row decoder 2040 may select a memory block corresponding to a block address from among the plurality of memory blocks BLK1 to BLKz.

In some example embodiments, each of the plurality of memory blocks BLK1 to BLKz may be implemented as a main block of an erase unit.

In some example embodiments, each of the plurality of memory blocks BLK1 to BLKz may include a plurality of sub-blocks. Each sub-block may be a block of an erase unit.

Each of the memory cells included in the memory cell array 2010 may store one or more bits. For example, the memory cell may be a single level cell that stores 1-bit data. For example, the memory cell may be a multi-level cell that stores 2-bit data. For example, the memory cell may be a triple level cell that stores 3-bit data. For example, the memory cell may be a quad level cell (or a quadruple level cell) that stores 4-bit data. However, the example embodiments of the inventive concepts are not limited to the above-described examples, and the memory cell may store data of 5 bits or more.

In some example embodiments, the plurality of memory blocks BLK1 to BLKz may include at least one of a single level cell block including single level cells, a multilevel cell block including multilevel cells, a triple level cell block including triple level cells, and a quad level cell block including quad level cells. A portion of the plurality of memory blocks BLK1 to BLKz may be single level cell blocks, and other memory blocks may be multilevel cell blocks or triple level cell blocks.

When an erase voltage is applied to the memory cell array 2010, the memory cells may be in an ease state, and when a program voltage is applied to the memory cell array 2010, the memory cells may be in a program state. In this regard, each memory cell may have an erase state or at least one program state classified according to a threshold voltage. That is, states of the memory cell may include the erase state and the at least one program state, and a specific state of each memory cell may be the erase state or a specific program state. For example, a single level cell may have a threshold voltage distribution corresponding to the erase state or a threshold voltage distribution corresponding to the program state. For example, a multilevel cell may have a threshold voltage distribution corresponding to the erase state, a threshold voltage distribution corresponding to a first program state, a threshold voltage distribution corresponding to a second program state, or a threshold voltage distribution corresponding to a third program state. For example, a triple level cell may have 8 threshold voltage distributions. For example, a quad level cell may have 16 threshold voltage distributions. However, the example embodiments are not limited to the above-described examples, and when the memory cell stores data of 5 bits or more, the memory cell may have 32 or more threshold voltage distributions.

The control logic circuit 2020 may generally control various operations in the non-volatile memory device 2000. For example, the control logic circuit 2020 may output various control signals for writing data to the memory cell array 2010 or reading data from the memory cell array 2010 based on the command CMD, the address ADDR, and the control signal CTRL.

Various control signals output from the control logic circuit 2020 may be provided to the voltage generator 2030, the row decoder 2040, and the page buffer unit 2050. The control logic circuit 2020 may provide a voltage control signal CTRL_vol to the voltage generator 2030. The control logic circuit 2020 may provide a row address X-ADDR to the row decoder 2040. The control logic circuit 2020 may provide a column address Y-ADDR to the page buffer unit 2050.

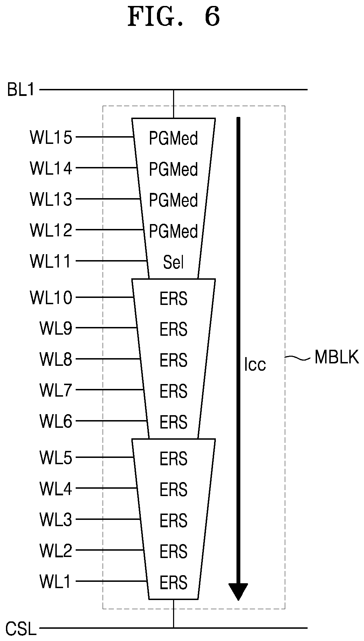

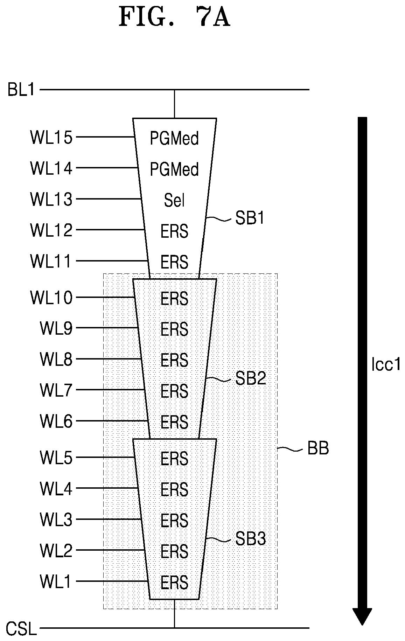

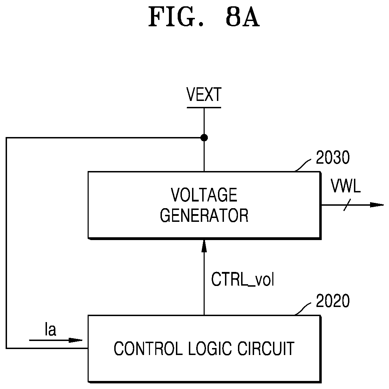

In some example embodiments, during a program verify operation or a read operation, the control logic circuit 2020 may detect a wordline charging current Iwdc. The wordline charging current Iwdc may be a current that varies according to states of a plurality of memory cells. The wordline charging current Iwdc may be a current that may be generated while voltage levels of the plurality of wordlines WL are changed by a plurality of wordline voltages VWL in a wordline setup operation (e.g., while the plurality of wordlines WL are set up or while the voltages of the plurality of wordlines WL are being charged). Because the wordline charging current Iwdc is a current generated when the plurality of wordlines WL are set up, the wordline charging current Iwdc may be related to the plurality of wordline voltages VWL. The wordline charging current Iwdc is described below with reference to FIGS. 8A to 8D. The control logic circuit 2020 may detect the wordline charging current Iwdc for a preset detection time. The control logic circuit 2020 may compensate for a cell current that varies according to states (e.g., the erase state or the program state) of pages included in specific sub-blocks (e.g., unselected sub-blocks) based on a detection value of the wordline charging current Iwdc and at least one reference value. The cell current is described below with reference to FIGS. 6 and 7A to 7D.

In some example embodiments, the control logic circuit 2020 may compensate for the cell current by increasing or decreasing a voltage level of a selected bitline.

In some example embodiments, the control logic circuit 2020 may compensate for the cell current by increasing or decreasing a time for discharging the voltage level of the selected bitline.

The voltage generator 2030 may be connected to the memory cell array 2010 through the plurality of wordlines WL. The voltage generator 2030 may generate various types of wordline voltages VWL for performing a program operation, a read operation, and an erase operation on the memory cell array 2010 based on an external supply voltage VEXT and the voltage control signal CTRL_vol. For example, the voltage generator 2030 may generate a program voltage, a read voltage, an erase voltage, a pass voltage (e.g., a program pass voltage, a read pass voltage, or a verify pass voltage), an erase allowance voltage, a verify voltage (e.g., a program verify voltage or an erase verify voltage), provided to the plurality of wordlines WL.

In some example embodiments, the external supply voltage VEXT may correspond to an external voltage as an EVC consumed by the non-volatile memory device 2000 or a boost voltage as a Vpp consumed by the non-volatile memory device 2000.

The plurality of wordline voltages VWL generated by the voltage generator 2030 may be provided to the plurality of wordlines WL. For example, the program voltage, the verify voltage, or the read voltage may be provided to a selected wordline among the plurality of wordlines WL, and the pass voltage may be provided to an unselected wordline among the plurality of wordlines WL. The selected wordline may be at least one wordline selected by the row address X-ADDR.

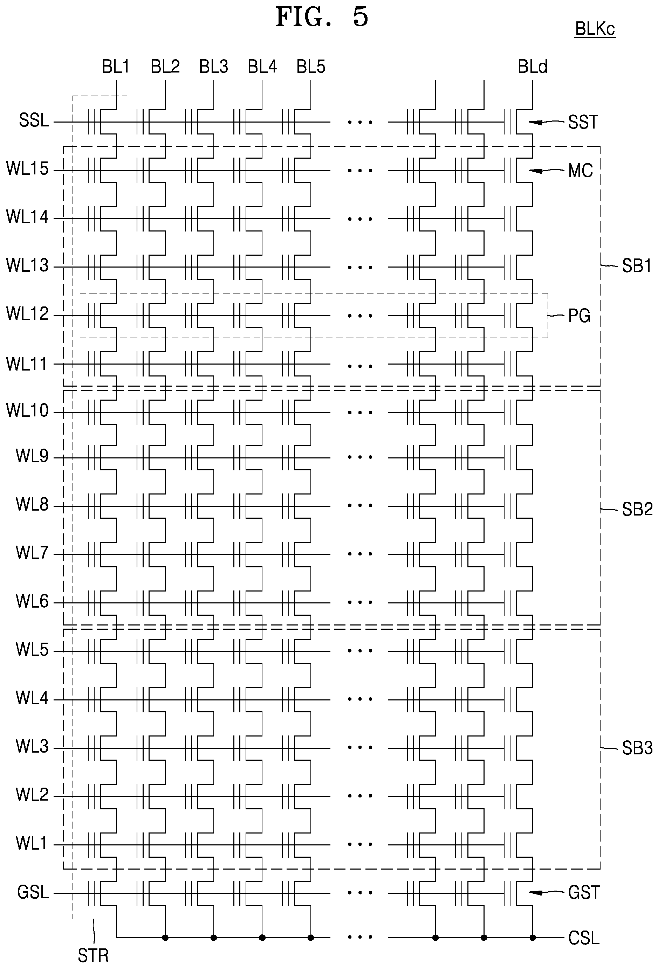

During the erase operation, the voltage generator 2030 may apply the erase voltage to a well and/or a common source line (e.g., "CSL" in FIG. 5) of the memory block. In addition, the voltage generator 2030 may apply the erase allowance voltage (e.g., ground voltage) to all the wordlines WL of the memory block or a portion of wordlines WL included in a portion of sub-blocks based on an erase address. During the erase verify operation, the voltage generator 2030 may apply the erase verify voltage to all the wordlines WL of one memory block or apply the erase verify voltage in units of wordlines.

During the program operation, the voltage generator 2030 may apply the program voltage to a selected wordline among the plurality of wordlines WL and apply the program pass voltage to unselected wordlines among the plurality of wordlines WL. In addition, during the program verify operation, the voltage generator 2030 may apply the program verify voltage to the selected wordline and the verify pass voltage to the unselected wordlines.

During the read operation, the voltage generator 2030 may apply the read voltage to the selected wordline among the plurality of wordlines WL and apply the read pass voltage to the unselected wordlines.

The row decoder 2040 may select a specific wordline from among the wordlines WL in response to the row address X-ADDR. For example, during the program operation, the row decoder 2040 may transmit the program voltage to the selected wordline according to the row address X-ADDR. The row decoder 2040 may select a portion of the string selection lines SSL or a portion of the ground selection lines GSL in response to the row address X-ADDR.

The page buffer unit 2050 may be connected to the memory cell array 2010 through the plurality of bitlines BL. The page buffer unit 2050 may select a portion of the plurality of bitlines BL in response to the column address Y-ADDR. During the verify operation (e.g., the erase verify operation or the program verify operation) or the read operation, the page buffer unit 2050 may operate as a sense amplifier to sense data stored in a selected memory cell through the selected bitline. Meanwhile, during the program operation, the page buffer unit 2050 may operate as a write driver to input data to be stored in the memory cell array 2010.

The page buffer unit 2050 may store data read from the memory cell array 2010, or may store data to be stored in the memory cell array 2010.

The page buffer unit 2050 may include a plurality of page buffers connected to the plurality of bitlines BL, respectively. The plurality of page buffers may be disposed corresponding to the respective bitlines, and each page buffer may include a plurality of latches. Hereinafter, the page buffer unit 2050 is defined as including the page buffer connected to each bitline. However, the terms may be differently defined in the embodiments, and for example, one page buffer may be provided corresponding to multiple bitlines.

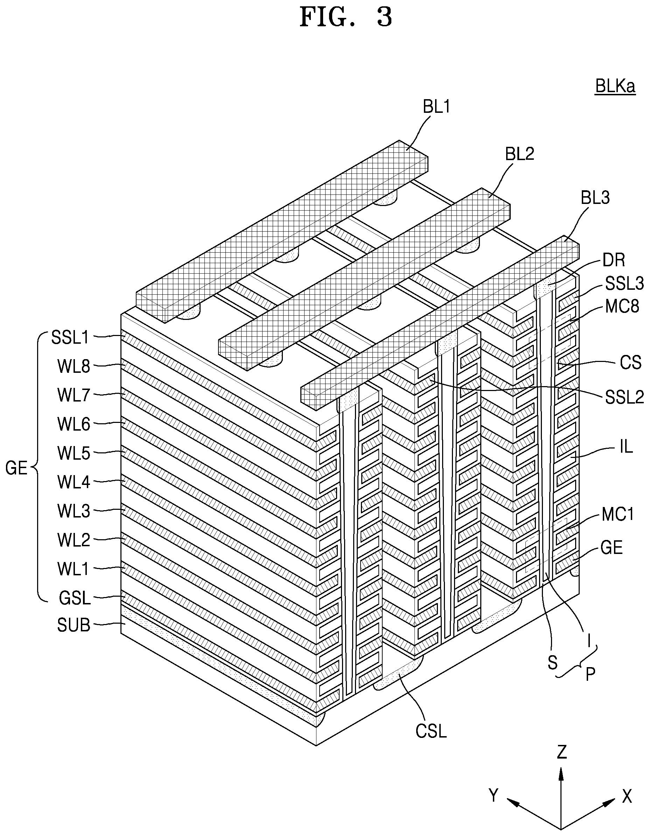

FIG. 3 is a perspective view of a memory block BLKa according to some example embodiments.

Referring to FIG. 3, a substrate SUB may be a polysilicon layer doped with an impurity of a first conductivity type (e.g., p type). The substrate SUB may include various materials and mixtures thereof. The common source line CSL extending in a first direction (e.g., a Y direction) and doped with impurities of a second conductivity type (e.g., n type) may be provided on the substrate SUB. A plurality of insulating layers IL extending in the first direction may be sequentially provided in a third direction (e.g., Z direction) on a region of the substrate SUB between the adjacent common source lines CSLs. A plurality of pillars P contacting the substrate SUB through the plurality of insulating layers IL in the third direction may be provided. A surface layer S of each of the plurality of pillars P may function as a channel region, and an inner layer I of each of the plurality of pillars P may include an insulating material or an air gap. In a region between the adjacent common source lines CSLs, a charge storage layer CS may be provided along the insulating layers IL, the plurality of pillars P, and an exposed surface of the substrate SUB, and gate electrodes GE such as the ground selection lines GSL, the string selection lines SSL, and wordlines WL1 to WL8 may be provided on an exposed surface of the charge storage layer CS. Drain contacts DR (or drains) doped with impurities having a second conductivity type may be provided on each of the plurality of pillars P. Bitlines BL1 to BL3 extending in a second direction (e.g., X direction) and spaced apart by a specific distance in the first direction may be provided on the drain contacts DR. The number of each of the ground selection lines GSL, string selection lines SSL1 to SSL3, the wordlines WL1 to WL8, memory cells MC1 to MC8, and bitlines BL1 to BL3 included in the memory block BLKa is an example, and may actually be more or less.

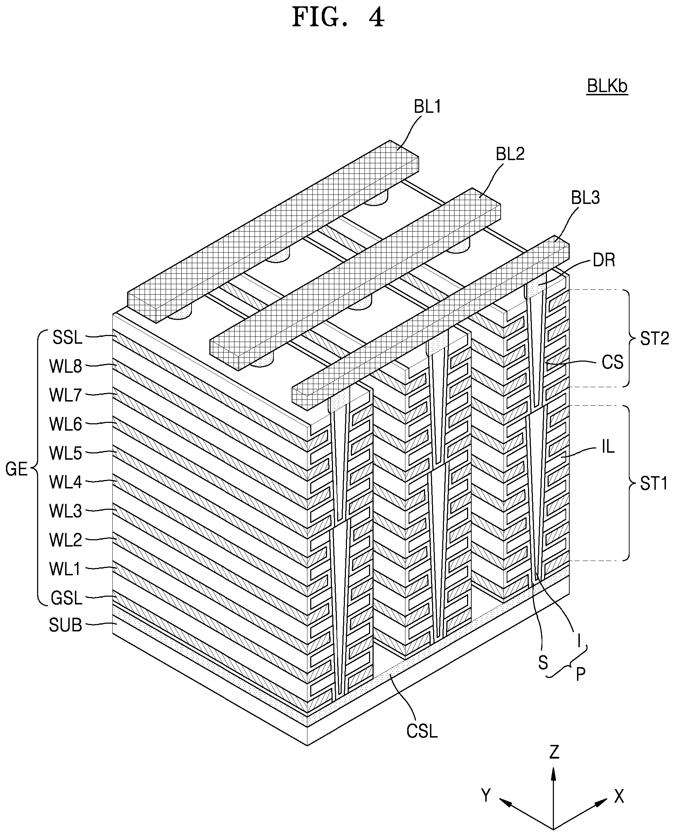

FIG. 4 is a perspective view of a memory block BLKb according to some example embodiments.

Referring to FIG. 4, the description of the memory block BLKb redundant with that of FIG. 3 is omitted. A first memory stack ST1 may be provided on the substrate SUB. In the memory block BLKb, a second memory stack ST2 generated by the same method on the first memory stack ST1 generated by the above-described method may be additionally provided. The drain contacts DR (or drains) are respectively provided on the plurality of pillars P extending to the second memory stack ST2.

FIG. 5 is a circuit diagram of a memory block BLKc according to some example embodiments.

Referring to FIG. 5, the memory block BLKc may include, for example, d (where d is an integer equal to or substantially equal to or greater than 2) strings STR in which a plurality of memory cells are connected in series. Each string STR may include a plurality of memory cells, a string selection transistor SST, and a ground selection transistor GST. The number of strings STR, the number of wordlines WL1 to WL15, and the number of bitlines BL (BL1 to BLd) may be changed in various ways according to some example embodiments.

In some example embodiments, the non-volatile memory device 2000 including the memory block BLKc may perform a program operation in units of a page PG corresponding to each of the wordlines WL1 to WL15. In some example embodiments, when the memory cells MCs are single level cells, one page PG may correspond to each wordline. For example, when the memory cells MC are multilevel cells, each wordline may correspond to a least significant bit (LSB) page and a most significant bit (MSB) page. For example, when the memory cells MC are triple level cells, each wordline may correspond to the LSB page, a central significant bit (CSB) page, and the MSB page.

In some example embodiments, when the non-volatile memory device 2000 supports a sub-block mode, the memory block BLKc may include a plurality of sub-blocks. For example, the memory block BLKc may include first to third sub-blocks SB1, SB2, and SB3. Each sub-block may include the memory cells MC connected to a portion of wordlines. For example, the first sub-block SB1 may include the memory cells MC connected to the eleventh to fifteenth wordlines WL11 to WL15. For example, the second sub-block SB2 may include the memory cells MC connected to the sixth to tenth wordlines WL6 to WL10. For example, the third sub-block SB3 may include the memory cells MC connected to the first to fifth wordlines WL1 to WL5. The number of sub-blocks included in the memory block BLKc and the number of each of wordlines and memory cells included in one sub-block may be changed in various ways according to some example embodiments. An erase operation may be performed for each of the first to third sub-blocks SB1, SB2, and SB3 according to some example embodiments. That is, the erase operation may be performed in units of sub-blocks.

FIG. 6 is a diagram illustrating a main block MBLK of some example embodiments of the inventive concepts.

Referring to FIG. 6, the main block MBLK may be a memory block that does not include a plurality of sub-blocks. An erase operation may be performed in unit of the main block MBLK according to some example embodiments. The main block MBLK may include the first to fifteenth wordlines WL1 to WL15. The number of wordlines included in the main block MBLK may be determined in various ways according to some example embodiments.

In the non-volatile memory device 2000 including the main block MBLK, the order of pages programmed in the main block MBLK may be previously determined. For example, pages may be sequentially programmed from the fifteenth wordline WL15 to the first wordline WL1. Specifically, a page corresponding to the fifteenth wordline WL15 may be programmed first, and a page corresponding to the first wordline WL1 may be programmed last. In this case, a cell current Icc flowing through a first bitline BL1 may flow in a direction from the fifteenth wordline WL15 to the first wordline WL1. Example embodiments of the inventive concepts are not limited to that shown in FIG. 6. As another example, pages may be sequentially programmed from the first wordline WL1 to the fifteenth wordline WL15. In this case, the cell current Icc may flow in a direction from the first wordline WL1 to the fifteenth wordline WL15. The magnitude of the cell current Icc may be constant.

Because the order of pages programmed in the main block MBLK is determined, pages programmed before a currently selected wordline Sel with respect to the currently selected wordline Sel may be predicted to be in a program state PGMed, pages to be programmed after the currently selected wordline Sel may be predicted to be in an erase state ERS, and a compensation operation for accurately confirming data is possible on a memory cell in a program verify operation or a read operation. For example, it is assumed that pages are programmed sequentially from the fifteenth wordline WL15 to the first wordline WL1, and that the currently selected wordline Sel is the eleventh wordline WL11. In this case, all memory cells connected to the first to tenth wordlines WL1 to WL10 may be in the erase state ERS.

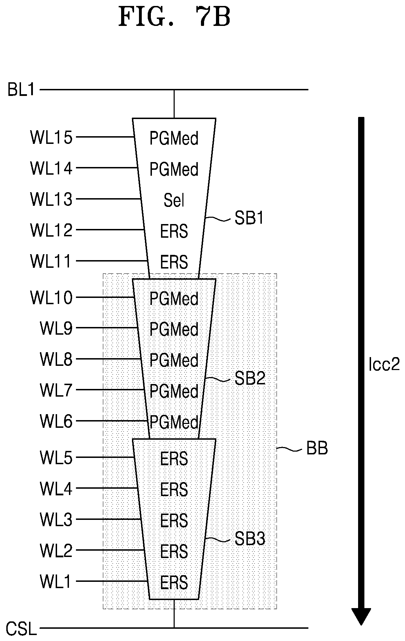

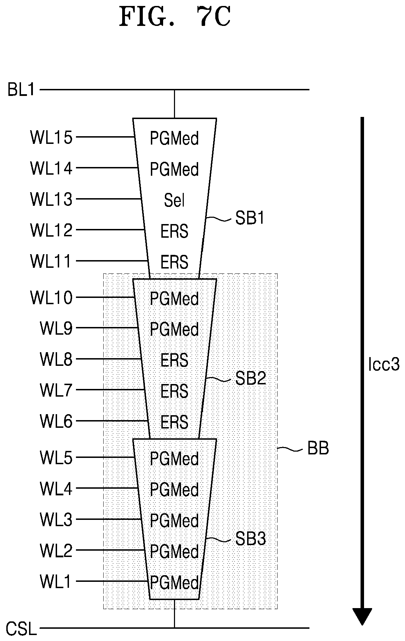

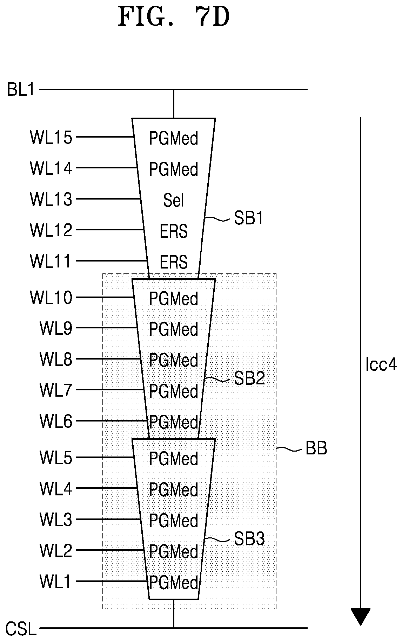

FIGS. 7A, 7B, 7C, and 7D are diagrams illustrating the first to third sub-blocks SB1, SB2, and SB3 of some example embodiments of the inventive concepts.

Referring to FIGS. 7A, 7B, 7C, and 7D, an erase operation may be performed for each of the first to third sub-blocks SB1, SB2, and SB3, and each of the first to third sub-blocks SB1, SB2, and SB3 may include memory cells connected to 5 wordlines. However, the example embodiments are not limited thereto, and the number of sub-blocks and the number of wordlines included in each sub-block may vary according to some example embodiments.

As described above with reference to FIG. 6, the order of pages programmed in each of the first to third sub-blocks SB1, SB2, and SB3 is determined. However, the order of pages programmed between the first to third sub-blocks SB1, SB2, and SB3 is not determined. Therefore, when sub-blocks different from a sub-block including the currently selected wordline Sel are referred to as unselected sub-blocks (or sister blocks), the unselected sub-blocks are included in a black box BB, and the control logic circuit 2020 does not know whether pages included in the unselected sub-blocks have been programmed or erased.

Meanwhile, the magnitude of the cell current Icc may vary according to states (e.g., an erase state or a program state) of pages included in the unselected sub-blocks. For example, it is assumed that the thirteenth wordline WL13 included in the first sub-block SB1 is the selected wordline, and the second and third sub-blocks SB2 and SB3 are the unselected sub-blocks. Referring to FIG. 7A, when pages of the second and third sub-blocks SB2 and SB3 all have an erase state, a first cell current Icc1 having the largest magnitude may be generated. Referring to FIG. 7B, when a ratio between pages having a program state and pages having an erase state in the unselected sub-blocks is 1:1 (e.g., all the pages of the second sub-block SB2 have a program state and all the pages of the third sub-block SB3 have an erase state or vice versa), a second cell current Icc2 having the magnitude smaller than the magnitude of the first cell current Icc1 may be generated. Referring to FIG. 7C, when pages having a program state are more than pages having an erase state in the unselected sub-blocks, a third cell current Icc3 having the magnitude smaller than the magnitude of the second cell current Icc2 may be generated. Referring to FIG. 7D, when the pages of the second and third sub-blocks SB2 and SB3 all have a program state, fourth cell current Icc4 having the smallest magnitude may be generated. Because the memory cell may degrade as the magnitude of the cell current Icc varies, the reliability of data stored in the memory cell may degrade.

In some example embodiments, the control logic circuit 2020 may perform a read operation based on an address corresponding to a specific wordline included in a selected sub-block among a plurality of sub-blocks and a read command. For example, the control logic circuit 2020 may perform a first read operation based on a first address representing a physical address of the fifteenth wordline WL15 included in the first sub-block SB1 and a first read command.

In some example embodiments, the control logic circuit 2020 may perform a program operation based on an address corresponding to a specific wordline included in the selected sub-block among the plurality of sub-blocks and a write command. In this regard, a program verify operation may be performed on a specific wordline for each program loop. For example, the control logic circuit 2020 may perform a program execution operation and a program verify operation on the thirteenth wordline WL13 included in the first sub-block SB1 for each program loop.

During a read operation or a program verify operation, the control logic circuit 2020 may perform a compensation operation for ensuring the reliability of data stored in selected memory cells because it is not known what states pages of the black box BB have. In this regard, the amount of compensation desired in the compensation operation may vary according to the states of the pages of the black box BB. However, because the states of the pages of the black box BB are not known, the amount of compensation for the cell current Icc may be determined through the wordline charging current Iwdc corresponding to the cell current Icc that varies according to the states of the pages of the black box BB.

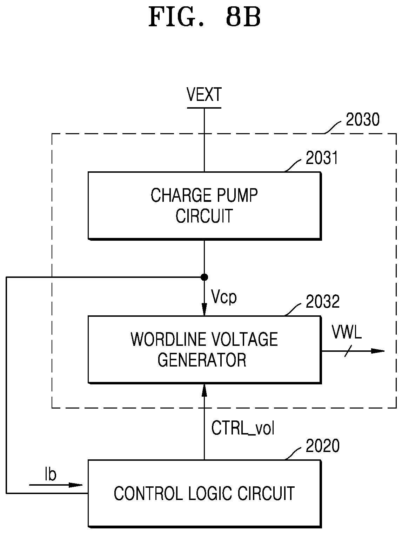

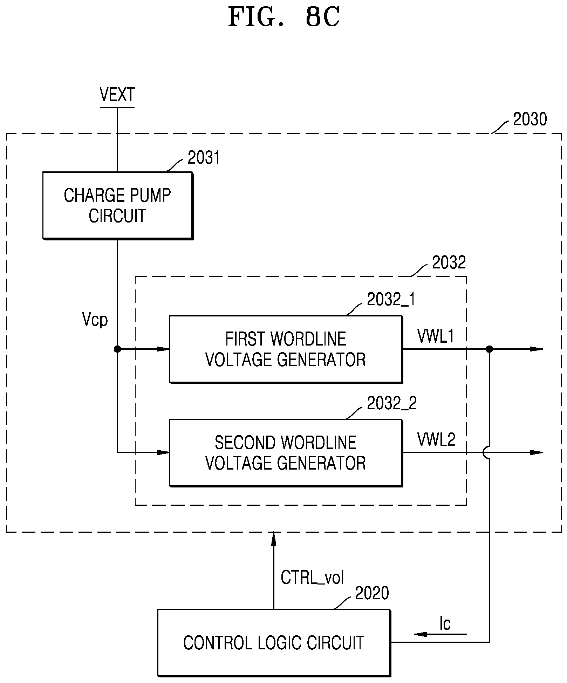

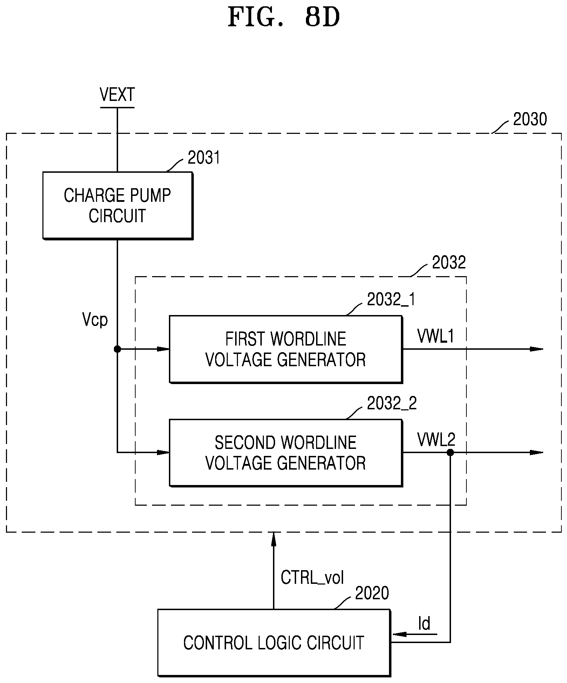

FIGS. 8A, 8B, 8C, and 8D are diagrams illustrating embodiments in which the wordline charging current Iwdc of some example embodiments are detected.

Referring to FIGS. 8A, 8B, 8C, and 8D, in some example embodiments, the voltage generator 2030 may generate an internal supply voltage Vcp based on the external supply voltage VEXT and generate the wordline voltages VWL based on the internal supply voltage Vcp.

In some example embodiments, the wordline voltages VWL may include a first wordline voltage VWL1 and a second wordline voltage VWL2. The first wordline voltage VWL1 may be a voltage provided to a selected wordline among the plurality of wordlines WL. For example, the first wordline voltage VWL1 may correspond to a program voltage, a read voltage, or a verify voltage. The second wordline voltage VWL2 may be a voltage provided to an unselected wordline among the plurality of wordlines WL. For example, the second wordline voltage VWL2 may correspond to a program pass voltage, a read pass voltage, or a verify pass voltage.

In some example embodiments, the control logic circuit 2020 may provide the voltage control signal CTRL_vol to the voltage generator 2030 based on a command and an address. For example, the control logic circuit 2020 may output the voltage control signal CTRL_vol instructing to generate a read voltage and a read pass voltage based on a read command and an address. For example, the control logic circuit 2020 may output a first voltage control signal instructing to generate a program voltage and a program pass voltage in a program execution operation based on a write command and address, and a second voltage control signal instructing to generate a program verify voltage and a verify pass voltage in a program verify operation.

In some example embodiments, the control logic circuit 2020 may detect the wordline charging current Iwdc based on at least one voltage of the external supply voltage VEXT, the internal supply voltage Vcp, the first wordline voltage VWL1, and the second wordline voltage VWL2 (for example, the wordline charging current Iwdc generated based on the at least one voltage of the external supply voltage VEXT, the internal supply voltage Vcp, the first wordline voltage VWL1, and the second wordline voltage VWL2).

In some example embodiments as shown in FIG. 8A, the control logic circuit 2020 may detect a current Ia generated by the external supply voltage VEXT as the wordline charging current Iwdc. The current Ia according to some example embodiments may correspond to an EVC or Vpp-based current consumed by a chip (e.g., the non-volatile memory device 2000).

In some example embodiments as shown in FIG. 8B, the voltage generator 2030 may include a charge pump circuit 2031 and a wordline voltage generator 2032. The charge pump circuit 2031 may generate the internal supply voltage Vcp by boosting the external supply voltage VEXT. The wordline voltage generator 2032 may generate the wordline voltages VWL by using the internal supply voltage Vcp. The control logic circuit 2020 may detect a current Ib generated by the internal supply voltage Vcp as the wordline charging current Iwdc. The current Ib according to some example embodiments may correspond to a current consumed by the charge pump circuit 2031.

In some example embodiments as shown in FIGS. 8C and 8D, the voltage generator 2030 may include the charge pump circuit 2031 and the wordline voltage generator 2032. The wordline voltage generator 2032 may include a first wordline voltage generator 2032_1 and a second wordline voltage generator 2032_2. The first wordline voltage generator 2032_1 may generate the first wordline voltage VWL1 to be provided to a selected wordline by using the internal supply voltage Vcp. The second wordline voltage generator 2032_2 may generate the second wordline voltage VWL2 to be provided to the unselected wordlines by using the internal supply voltage Vcp.

The control logic circuit 2020 according to some example embodiments as shown in FIG. 8C may detect a current Ic generated by the first wordline voltage VWL1 as the wordline charging current Iwdc. The current Ic according to some example embodiments may correspond to a current consumed by the first wordline voltage generator 2032_1.

The control logic circuit 2020 according to some example embodiments as shown in FIG. 8D may detect a current Id generated by the second wordline voltage VWL2 as the wordline charging current Iwdc. The current Id according to some example embodiments may correspond to a current consumed by the second wordline voltage generator 2032_2.

According to the above-described embodiments, the wordline charging current Iwdc that varies according to the states of pages included in the unselected sub-blocks may be detected, thereby limiting and/or preventing degradation of the memory cell and/or improving the reliability of data stored in the memory cell.

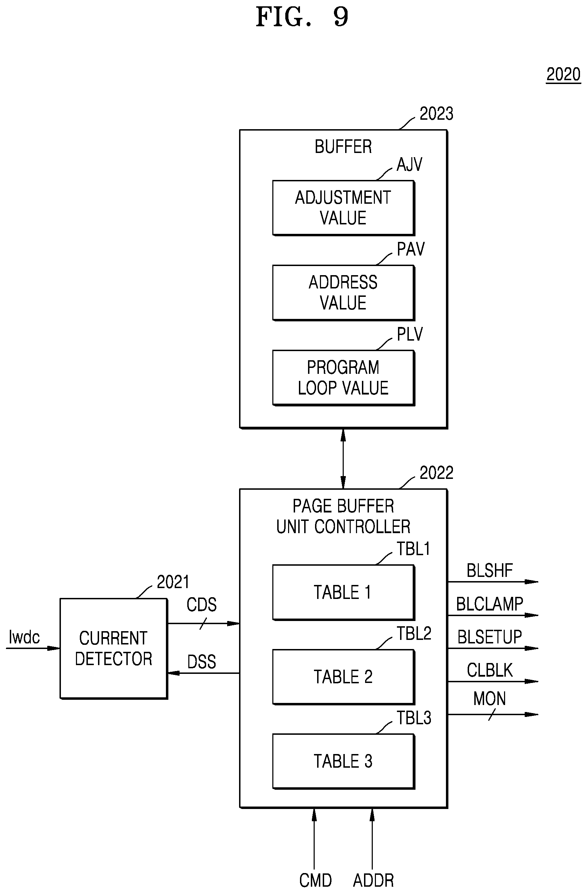

FIG. 9 is a block diagram of the control logic circuit 2020 according to some example embodiments.

Referring to FIG. 9, in some example embodiments, the control logic circuit 2020 may include a current detector 2021, a page buffer unit controller 2022, and a buffer 2023.

The current detector 2021 may detect the wordline charging current Iwdc that varies according to states of a plurality of memory cells for a preset detection time in a wordline setup operation, and may output at least one current detection signal CDS based on a detection value of the wordline charging current Iwdc and at least one reference value. Example embodiments in which the wordline charging current Iwdc is detected are the same as described above with reference to FIGS. 8A, 8B, 8C, and 8D.

In some example embodiments, when the detection value is greater than or equal to or substantially equal to the reference value, the current detector 2021 may output the current detection signal CDS having an activation level. The number of reference values is one or more, and two or more reference values may be different values. The number of reference values may be set according to a rate (or ratio) of a first number of pages having an erase state and a second number of pages having a program state in unselected sub-blocks. The ratio of the first number to the second number described above may be referred to as an erase-to-program ratio. For example, erase-to-program ratios may include 100:0 (%), 75:25 (%), 50:50 (%), 25:75 (%), and 0:100 (%). However, the example embodiments are not limited to the above-described example, and the erase-to-program ratios may be further subdivided than the above-described example, or may be less divided than the above-described example, and a specific value in the erase-to-program ratio may be determined in various ways. As types of erase-to-program ratios are further subdivided, a difference in the cell current Icc between the erase-to-program ratios may be compensated in more detail, and thus the reliability of the data may be further improved. On the other hand, the simpler the types of erase-to-program ratios are classified and implemented, the less overhead of a calculation process of compensating for the difference in the cell current Icc between the erase-to-program ratios, and thus, resource efficiency may also be improved.

Meanwhile, the current detection signal CDS may be a signal that informs the page buffer unit controller 2022 that a value of the wordline charging current Iwdc is greater than or equal to or substantially equal to a specific reference value. The number of current detection signals CDS may correspond to the number of reference values.

The page buffer unit controller 2022 may generate control signals to be provided to a bitline based on the command CMD. For example, when the command CMD is a read command or a write command, the page buffer unit controller 2022 may generate a bitline shutoff control signal BLSHF, a bitline clamping control signal BLCLAMP, a bitline setup control signal BLSETUP, a bitline connection control signal CLBLK, and at least one monitoring control signal MON during a read operation or a program verify operation. Each of the bitline shutoff control signal BLSHF, the bitline clamping control signal BLCLAMP, the bitline setup control signal BLSETUP, the bitline connection control signal CLBLK, and the at least one monitoring control signal MON may have an activation level at a specific time.

The page buffer unit controller 2022 may adjust at least one of a bitline voltage control signal set and the bitline connection control signal CLBLK based on the at least one current detection signal CDS having the activation level.

The bitline voltage control signal set may be a signal for adjusting a level of a voltage applied to the bitline. In some example embodiments, the bitline voltage control signal set may include at least one of the bitline shutoff control signal BLSHF and the bitline clamping control signal BLCLAMP.

In some example embodiments, the page buffer unit controller 2022 may adjust at least one control signal based on the at least one current detection signal CDS having the activation level and at least one of first to third tables TBL1, TBL2, and TBL3.

The first to third tables TBL1, TBL2, and TBL3 according to some example embodiments may include control parameters according to the activated current detection signal CDS. The control parameters may include, for example, a voltage level of a signal, a time for discharging a pre-charged voltage to a sensing node, or a combination thereof. The activated current detection signal CDS may be indicated as "active CDS" in the first to third tables TBL1, TBL2, and TBL3. In some example embodiments, the number of current detection signal CDS may be 10, and erase-to-program ratios may include 0:100 (%), 10:90, 20:80, 30:70, 40:60, 50:50, 60:40, 70:30, 80:20, 90:0, and 100:0. However, the example embodiments are not limited to the above-described example. The 10 current detection signals may be indicated as "CDSa" to "CDSj" in the first to third tables TBL1, TBL2, and TBL3. The erase-to-program ratio is expressed as "ERS:PGM ratio" in the first to third tables TBL1, TBL2, and TBL3. The number of the activated current detection signals CDS may vary according to the magnitude of a detection value of the wordline charging current Iwdc, and the magnitude of the detection value of the wordline charging current Iwdc may vary according to the erase-to-program ratio. Therefore, the number of the activated current detection signals CDS may correspond to the erase-to-program ratio, and in some cases, the erase-to-program ratios may be omitted from the first to third tables TBL1, TBL2, and TBL3.

In some example embodiments, the control logic circuit 2020 may determine an activation level at which at least one of the bitline shutoff control signal BLSHF and the bitline clamping control signal BLCLAMP is activated by using the first table TBL1.

In some example embodiments, the first table TBL1 may include erase-to-program ratios and activation level of the bitline voltage control signal according to the number of current detection signals CDS to be activated, as shown in Table 1 below.

**[Table 1]**

| | | | | | | | | | | | |
|---|---|---|---|---|---|---|---|---|---|---|---|
| ERS:PGM ratio | 0 : 100 | 10 : 90 | 20 : 80 | 30 : 70 | 40 : 60 | 50 : 50 | 60 : 40 | 70 : 30 | 80 : 20 | 90 : 10 | 100 : 0 |
| active CDS | N/ A | CDS a | CDS a ~ CDS b | CDS a ~ CDS c | CDS a ~ CDS d | CDS a ~ CDS e | CDS a ~ CDS f | CDS a ~ CDS g | CDS a ~ CDS h | CDS a ~ CDS i | CDS a ~ CDS j |
| vBL | V1 | V2 | V3 | V4 | V5 | V6 | V7 | V8 | V9 | V10 | V11 |
| vBLSHF | V1' | V2' | V3' | V4' | V5' | V6' | V7' | V8' | V9' | V10' | V11' |
| vBLCLAM P | V1 " | V2" | V3" | V4" | V5" | V6" | V7" | V8" | V9" | V10" | V11" |

In [Table 1], "N/A" means that all current detection signals CDS are deactivated. "vBL" is a voltage level of the bitline selected during the read operation or the program verify operation, "vBLSHF" is an activation level of the bitline shutoff control signal BLSHF during the read operation or the program verify operation, and "vBLCLAMP" is an activation level of the bitline clamping control signal BLCLAMP during the read operation or the program verify operation. "vBL" may be a factor determined by "vBLSHF" and "vBLCLAMP". That is, the page buffer unit controller 2022 may set at least one of "vBLSHF" and "vBLCLAMP" in order to set a specific voltage level of "vBL". The magnitude may be reduced in the order of "V1", "V2", "V3", "V4", "V5", "V6", "V7", "V8", "V9", "V10", and "V11". That is, "V1" may be the largest and "V11" may be the smallest. The magnitude of each of "V1'", "V2'", "V3'", "V4'", "V5'", "V6'", "V7'", "V8'", "V9''', "V10'", and "V11'" is also the same as magnitude relationship between "V1" to "V11". That is, "V1'" may be the largest and "V11'" may be the smallest. "V1"" to "V11"" are also the same as the magnitude relationship between "V1" to "V11" and "V1'" to "V11'". That is, "V1"" may be the largest and "V11"" may be the smallest. "CDSa", "CDSa to CDSb", "CDSa to CDSc", "CDSa to CDSd", "CDSa to CDSe", "CDSa to CDSf', "CDSa to CDSg", "CDSa to CDSh", "CDSa to CDSi", and "CDSa to CDSj" may be activated current detection signals. For example, "CDSa to CDSb" include "CDSa" and "CDSb", "CDSa to CDSc" include "CDSa", "CDSb", and "CDSc", "CDSa to CDSd" include "CDSa to CDSc" and "CDSd", and likewise, "CDSa to CDSe", "CDSa to CDSf", "CDSa to CDSg", "CDSa to CDSh", "CDSa to CDSi", and "CDSa to CDSj" also include a plurality of current detection signals similar to those described above.

In some example embodiments, the control logic circuit 2020 may determine an activation period during which the bitline connection control signal CLBLK is activated by using the second table TBL2. The activation period during which the bitline connection control signal CLBLK is activated may correspond to a time for discharging the pre-charged voltage to the sensing node.

In some example embodiments, the second table TBL2 may include erase-to-program ratios and activation period of the bitline connection control signal CLBLK according to the number of current detection signals CDS to be activated, as shown in Table 2 below.

**[Table 2]**

| | | | | | | | | | | | |
|---|---|---|---|---|---|---|---|---|---|---|---|
| ERS:PG M ratio | 0 : 100 | 10 : 90 | 20 : 80 | 30 : 70 | 40 : 60 | 50 : 50 | 60 : 40 | 70 : 30 | 80 : 20 | 90 : 10 | 100 : 0 |
| active CDS | N/ A | CDS a | CDS a ~ CDS b | CDS a ~ CDS c | CDS a ~ CDS d | CDS a ~ CDS e | CDS a ~ CDS f | CDS a ~ CDS g | CDS a ~ CDS h | CDS a ~ CDSi | CDS a ~ CDSj |
| SO discharge time | t1 | t2 | t3 | t4 | t5 | t6 | t7 | t8 | t9 | t10 | t11 |

In [Table 2], "N/A", "CDSa", "CDSa and CDSb", "CDSa to CDSc", "CDSa to CDSd", "CDSa to CDSe", "CDSa to CDSf", "CDSa to CDSg", "CDSa~CDSh", "CDSa to CDSi", and "CDSa to CDSj" are the same as those in [Table 1]. "SO discharge time" is a time for discharging a pre-charged voltage to the sensing node. The "SO discharge time" may correspond to an activation period of the bitline connection control signal CLBLK. That is, the page buffer unit controller 2022 may set the "SO discharge time" by varying the activation period of the bitline connection control signal CLBLK. The magnitude may be reduced in the order of "t1", "t2", "t3", "t4", "t5", "t6", "t7", "t8", "t9", "t10", and "t11". That is, "t1" may be the largest and "t11" may be the smallest.

In some example embodiments, the control logic circuit 2020 may determine the activation level of a bitline voltage control signal set (e.g., BLSHF/BLCLAMP) and the activation period of the bitline connection control signal CLBLK by using the third table TBL3.

In some example embodiments, the third table TBL3 is shown in Table 3 below.

**[Table 3]**

| | | | | | | | | | | | |
|---|---|---|---|---|---|---|---|---|---|---|---|
| ERS:PGM ratio | 0 : 100 | 10 : 90 | 20 : 80 | 30 : 70 | 40 : 60 | 50 : 50 | 60 : 40 | 70 : 30 | 80 : 20 | 90 : 10 | 100 : 0 |
| active CDS | N/A | CDS a | CDS a ~ CDS b | CDS a ~ CDS c | CDS a ~ CDS d | CDS a ~ CDS e | CDS a ~ CDS f | CDS a ~ CDS g | CDS a ~ CDS h | CDS a ~ CDS i | CDS a ~ CDS j |
| SO Discharge Time | t12 | t13 | t14 | t15 | t16 | t17 | t18 | t19 | t20 | t21 | t22 |
| vBL | V12 | V13 | V14 | V15 | V16 | V17 | V18 | V19 | V20 | V21 | V22 |
| vBLSHF | V12' | V13' | V14' | V15' | V16' | V17' | V18' | V19' | V20' | V21' | V22' |
| vBLCLAM P | V12 " | V13" | V14" | V15" | V16" | V17" | V18" | V19" | V20" | V21" | V22" |

In [Table 3], "N/A", "CDSa", "CDSa and CDSb", "CDSa to CDSc", "CDSa to CDSd", "CDSa to CDSe", "CDSa to CDSf", "CDSa to CDSg", "CDSa to CDSh", "CDSa to CDSi", "CDSa to CDSj", and "SO discharge time" are the same as those in [Table 1] and [Table 2]. Because "t12" to "t22", "V12" to "V22", "V12'" to "V22'", and "V12"" to "V22"" are combined to compensate for the cell current Icc, the magnitude relationship of each of "t12" to "t22", "V12" to "V22", "V12'" to "V22'", and "V12"" to "V22"" is not uniformly determined, unlike [Table 1] and [Table 2], and may be optimized in various ways according to some example embodiments.

In some example embodiments, when at least one control signal of a bitline voltage control signal set and the bitline connection control signal CLBLK is adjusted during a read operation or a program verify operation, the page buffer unit controller 2022 may store an adjustment value AJV with respect to the control signal in the buffer 2023. The adjustment value AJV may include, for example, a value of "vBL" (e.g., "vBLSHF" and/or "vBLCLAMP") and/or "SO Discharge Time" selected from the first to third tables TBL1, TBL2, and TBL3.

In some example embodiments, the page buffer unit controller 2022 may store an address value PAV in the buffer 2023 during the read operation or the program verify operation. When the command CMD is a read command or a write command, the page buffer unit controller 2022 may confirm whether a sub-block including a page that is a target of a currently performed operation (e.g., the read operation or the program verify operation) is the same as a sub-block including a page that is a target of a previously performed operation, based on the address value PAV and a value of the currently received address ADDR. When the two sub-blocks are the same, during the currently performed operation, the page buffer unit controller 2022 may provide the activated detection stop signal DSS to the current detector 2021, and the current detector 2021 may stop or skip the operation of detecting the wordline charging current Iwdc in response to the activated detection stop signal DSS. When the two sub-blocks are different, the page buffer unit controller 2022 may deactivate the detection stop signal DSS, and the current detector 2021 may detect the wordline charging current Iwdc.

In some example embodiments, the page buffer unit controller 2022 may store a program loop value PLV currently performed during the program verify operation in the buffer 2023. When the command CMD is a write command and the program loop value PLV stored in the current buffer 2023 is 1 or there is no program loop value PLV, a current program loop in a program operation to be performed may be an initial program loop. During a program verify operation of the initial program loop, the page buffer unit controller 2022 may deactivate the detection stop signal DSS. When the execution of the initial program loop is completed, the page buffer unit controller 2022 may activate the detection stop signal DSS.

The buffer 2023 may store data received from the page buffer unit controller 2022, and may provide the stored data to the page buffer unit controller 2022. In some example embodiments, the buffer 2023 may store the adjustment value AJV, the address value PAV, and/or the program loop value PLV.

According to the above-described embodiments, control signals used in the read operation or the program verify operation are adjusted according to the detected wordline charging current Iwdc, thereby reducing degradation of a memory cell due to the variable cell current Icc, and/or improving the reliability of data.

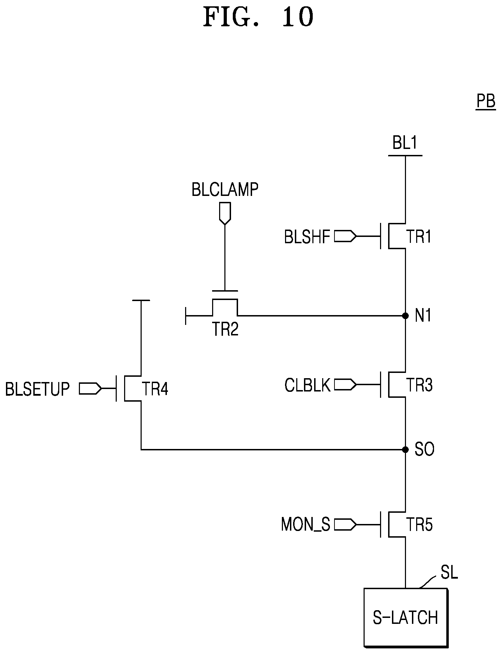

FIG. 10 is a diagram illustrating a page buffer PB according to some example embodiments.

In FIG. 10, the page buffer PB may be included in the page buffer units 122 and 2050 of FIGS. 1 and 2. The page buffer PB may be connected to an arbitrary bitline. Referring to FIG. 10, for example, the page buffer PB may be connected to the first bitline BL1. However, the example embodiments are not limited to the above-described example.

The page buffer PB may include first to fifth transistors TR1, TR2, TR3, TR4, and TR5 and a sense latch (S- latch) SL.

The first transistor TR1 may be connected between the first bitline BL1 and a first node N1, and may be driven by the bitline shutoff control signal BLSHF. The second transistor TR2 may be connected to the first node N1 and may be driven by the bitline clamping control signal BLCLAMP. When the bitline clamping control signal BLCLAMP is activated, the second transistor TR2 may clamp a voltage of the first node N1. The third transistor TR3 may be connected between a sensing node SO and the first node N1, and may be driven by the bitline connection control signal CLBLK. The fourth transistor TR4 may be connected to the sensing node SO and may be driven by the bitline setup control signal BLSETUP. When the bitline setup control signal BLSETUP is activated, the fourth transistor TR4 may pre-charge a voltage of the sensing node SO to a pre-charge level. The fifth transistor TR5 may be connected between the sensing node SO and the sense latch SL, and may be driven by a sensing monitoring control signal MON_S. For example, the first to fifth transistors TR1, TR2, TR3, TR4, and TR5 may be implemented as NMOS transistors. However, the example embodiments are not limited to the above-described example.

The sense latch SL may store data stored in a memory cell or a sensing result of a threshold voltage of the memory cell during a read operation or a program verify operation. In addition, the sense latch SL may be used to apply a program bitline voltage or a program prohibition voltage to the first bitline BL1 during a program execution operation.

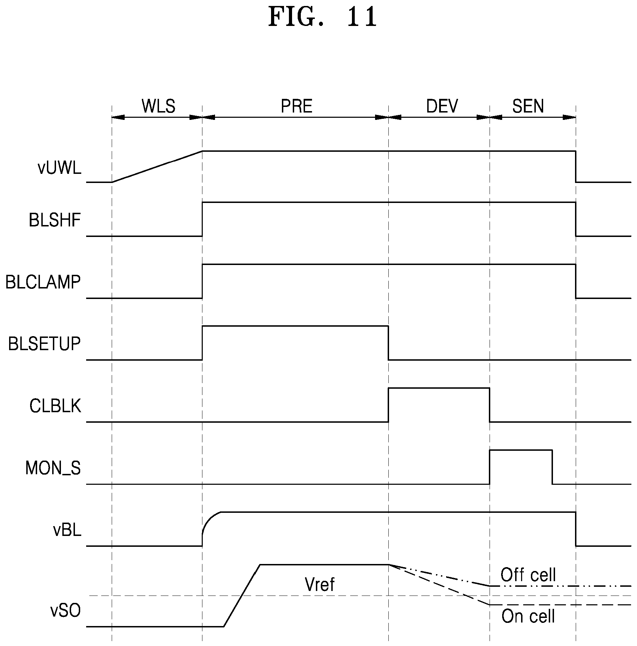

FIG. 11 is a timing diagram of signals provided to the page buffer PB of FIG. 10.

Referring to FIG. 11, a read operation and a program verify operation may include a wordline setup operation WLS, a pre-charge operation PRE, a develop operation DEV, and a sensing operation SEN.

During a period in which the wordline setup operation WLS is performed, voltage levels of the plurality of wordlines WL increase. For example, when the wordline setup operation WLS of the read operation is performed, a read voltage is applied to a selected wordline among the plurality of wordlines WL, and a read pass voltage is applied to unselected wordlines among the plurality of wordlines WL. When the wordline setup operation WLS of the read operation is completed, a voltage level of the selected wordline may reach a voltage level of a read voltage, and voltage levels vUWL of the unselected wordlines may reach a voltage level of a read pass voltage. For example, when the wordline setup operation WLS of the program verify operation is performed, a verify voltage is applied to the selected wordline among the plurality of wordlines WL, and a verify pass voltage is applied to unselected wordlines among the plurality of wordlines WL. When the wordline setup operation WLS of the program verify operation is completed, the voltage level of the selected wordline may reach a voltage level of a verify voltage, and the voltage levels vUWL of the unselected wordlines may reach a voltage level of a verify pass voltage.

During the pre-charge operation PRE, each of the bitline shutoff control signal BLSHF, the bitline clamping control signal BLCLAMP, and the bitline setup control signal BLSETUP is activated. For example, when the first transistor TR1, the second transistor TR2, and the fourth transistor TR4 of the page buffer PB are implemented as NMOS transistors, the signal level of each of the bitline shutoff control signal BLSHF, the bitline clamping control signal BLCLAMP, and the bitline setup control signal BLSETUP may increase to a specific signal level when the pre-charge operation PRE starts. In this case, voltage levels vBL of selected bitlines may increase. After each of the bitline shutoff control signal BLSHF, the bitline clamping control signal BLCLAMP, and the bitline setup control signal BLSETUP is activated, a voltage level vSO of the sensing node SO may increase.

When the develop operation DEV is performed, the bitline setup control signal BLSETUP is deactivated. While the develop operation DEV is performed, the bitline connection control signal CLBLK is activated. For example, when the third transistor TR3 and the fourth transistor TR4 of the page buffer PB are implemented as NMOS transistors, the signal level of the bitline setup control signal BLSETUP decreases to a specific signal level and the signal level of the bitline connection control signal CLBLK increases to a specific signal level when the develop operation DEV starts. During a period during which the develop operation DEV is performed, a voltage pre-charged to the sensing node SO is discharged, and the voltage level vSO of the sensing node SO decreases. The degree (or inclination) to which the voltage level vSO of the sensing node SO decreases may vary according to a threshold voltage distribution of memory cells. When a memory cell is an on-cell, the voltage level vSO of the sensing node SO may rapidly decrease to a voltage level lower than a reference voltage level Vref. When the memory cell is an off cell, the voltage level vSO of the sensing node SO may gradually decrease to a voltage level higher than the reference voltage level Vref.

During a period in which the sensing operation SEN is performed, the sensing monitoring control signal MON_S may be activated. The sense latch SL may store data (or a sensing result) of the memory cell in response to the activated sensing monitoring control signal MON_S.

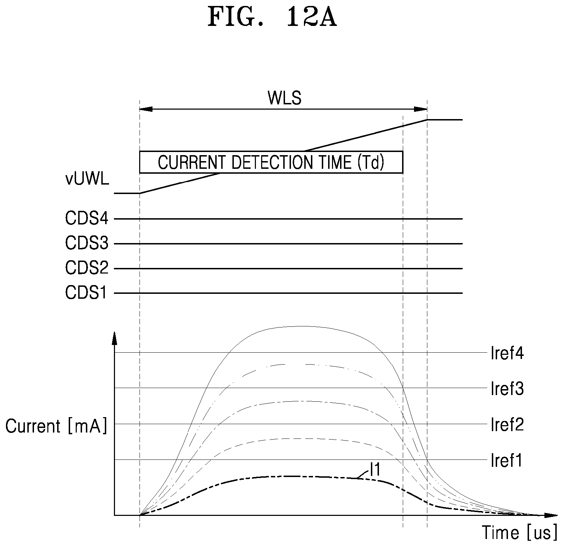

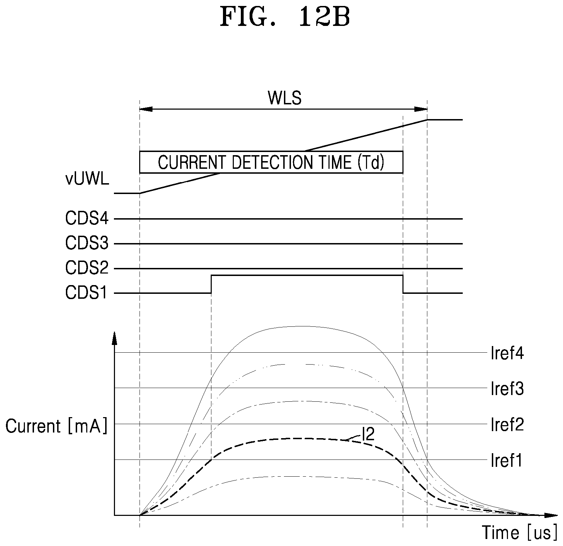

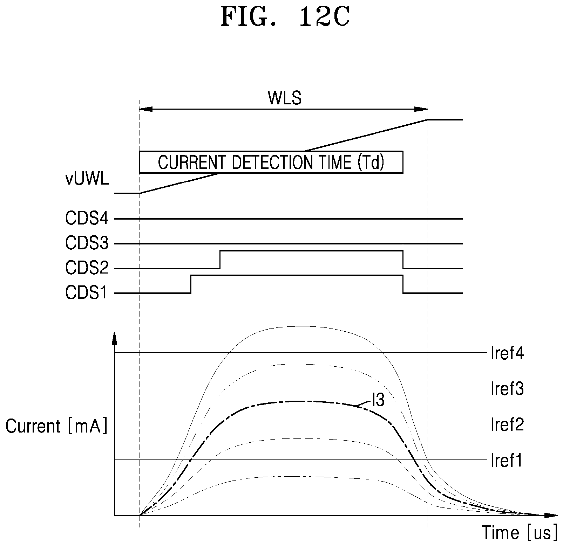

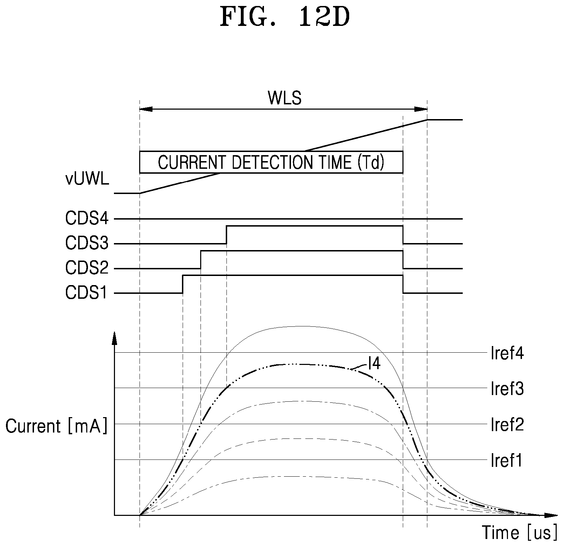

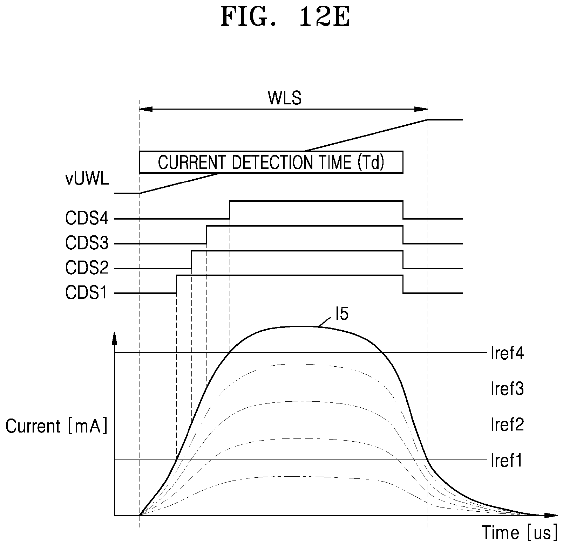

FIGS. 12A, 12B, 12C, 12D, and 12E are timing diagrams of first to fourth current detection signals CDS1, CDS2, CDS3, and CDS4 according to some example embodiments.

Referring to FIGS. 12A, 12B, 12C, 12D, and 12E, in graphs shown in FIGS. 12A to 12E, respectively, a horizontal axis represents the time (unit of microsecond (µs)) and a vertical axis represents the current (unit of milliampere (mA)). The current representing the vertical axis of the graph may correspond to the wordline charging current Iwdc according to an erase-to-program ratio. In FIGS. 12A to 12E, types of erase-to-program ratios are assumed to be five types. For example, five erase-to-program ratios may be 0:100 (%), 25:75, 50:50, 75:25, and 100:0. However, the example embodiments are not limited thereto, and the number of erase-to-program ratios may be changed in various ways according to some example embodiments. Shapes of the graphs shown in FIGS. 12A to 12E may be similar to each other. On the other hand, when the erase-to-program ratios are divided into 5, the number of first to fourth current detection signals CDS1, CDS2, CDS3, and CDS4 and the number of first to fourth reference currents Iref1, Iref2, Iref3, and Iref4 may be implemented as 4. As shown in FIGS. 12A to 12E, for example, among the first to fourth reference currents Iref1, Iref2, Iref3, and Iref4, the first reference current Iref1 may be the smallest, and the fourth reference current Iref4 may be the largest. The page buffer unit controller 2022 may detect a current corresponding to the wordline charging current Iwdc by using the first to fourth current detection signals CDS1, CDS2, CDS3, and CDS4 and the first to fourth reference currents Iref1, Iref2, Iref3, and Iref4, thereby confirming the five erase-to-program ratios.

Referring to FIG. 12A, a first current I1 may correspond to the wordline charging current Iwdc detected when the erase-to-program ratio is 0: 100 (%). In the wordline setup operation WLS, the magnitude of the first current I1 during a preset detection time Td may be smaller than the magnitude of the first reference current Iref1. In this case, the first to fourth current detection signals CDS1, CDS2, CDS3, and CDS4 of the current detector 2021 may be deactivated.

Referring to FIG. 12B, a second current I2 may correspond to the wordline charging current Iwdc detected when the erase-to-program ratio is 25:75 (%). When the magnitude of the second current I2 is greater than or equal to or substantially equal to the magnitude of the first reference current Iref1, the first current detection signal CDS1 of the current detector 2021 may be activated. When the detection time Td expires, the activated first current detection signal CDS1 may be deactivated.

Referring to FIG. 12C, a third current I3 may correspond to the wordline charging current Iwdc detected when the erase-to-program ratio is 50:50 (%). When the magnitude of the third current I3 is greater than or equal to or substantially equal to the magnitude of the first reference current Iref1, the first current detection signal CDS1 of the current detector 2021 may be activated. When the magnitude of the third current I3 is greater than or equal to or substantially equal to the magnitude of the second reference current Iref2, the second current detection signal CDS2 of the current detector 2021 may be activated. When the detection time Td expires, the activated first current detection signal CDS1 and second current detection signal CDS2 may be deactivated.

Referring to FIG. 12D, a fourth current I4 may correspond to the wordline charging current Iwdc detected when the erase-to-program ratio is 75:25 (%). Similarly to the above description, when the magnitude of the fourth current I4 is greater than or equal to or substantially equal to the magnitude of each of the first to third reference currents Iref1, Iref2, and Iref3, each of the first to third current detection signals CDS1, CDS2, and CDS3 of the current detector 2021 may be activated. When the detection time Td expires, the activated first to third current detection signals CDS1, CDS2, and CDS3 may be deactivated.

Referring to FIG. 12E, a fifth current I5 may correspond to the wordline charging current Iwdc detected when the erase-to-program ratio is 100:0 (%). Similarly to the above description, when the magnitude of the fifth current I5 is greater than or equal to or substantially equal to the magnitude of each of the first to fourth reference currents Iref1, Iref2, Iref3, and Iref4, each of the first to fourth current detection signals CDS1, CDS2, CDS3, and CDS4 of the current detector 2021 may be activated.

In some example embodiments, the detection time Td may be less than or equal to or substantially equal to a period during which the wordline setup operation WLS is performed.

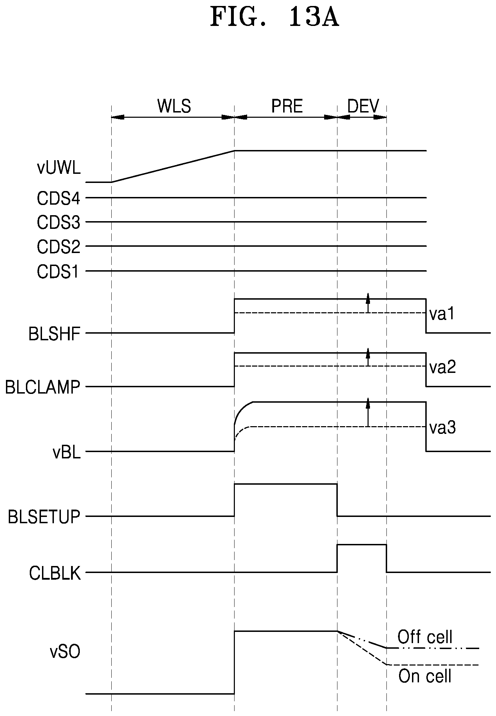

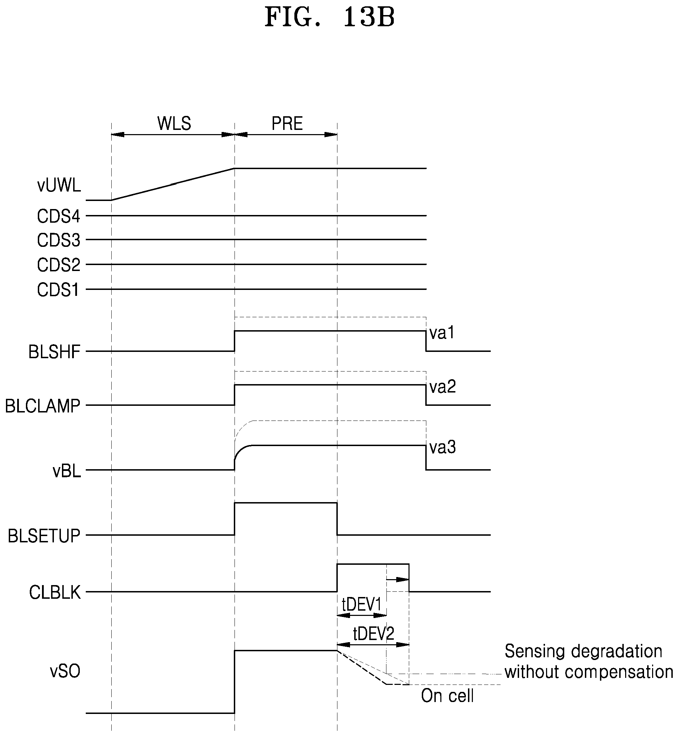

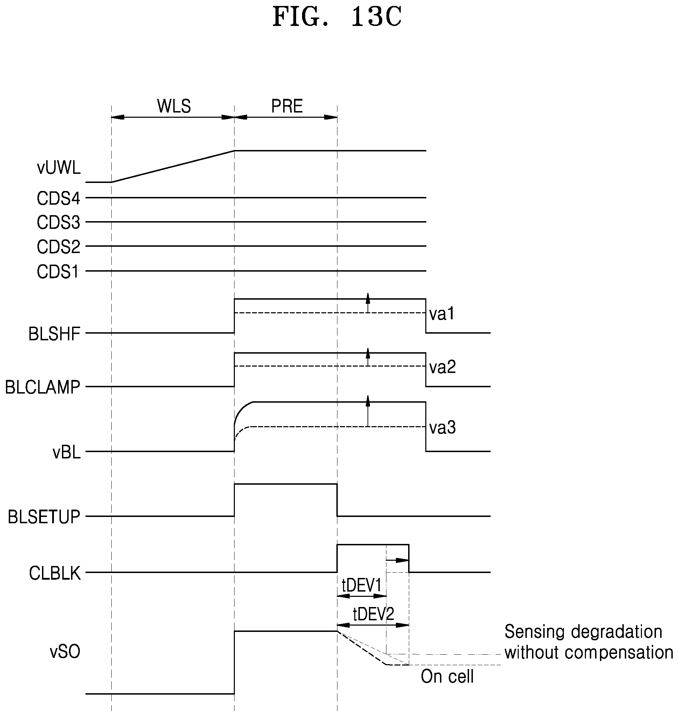

FIGS. 13A, 13B, and 13C are timing diagrams of control signals when the first current I1 of FIG. 12A is detected.

Referring to FIGS. 13A, 13B, and 13C, in some example embodiments, in order to compensate for the cell current Icc (or a difference between cell currents), the page buffer unit controller 2022 may adjust at least one control signal of a bitline voltage control signal set activated after the wordline setup operation WLS and the bitline connection control signal CLBLK activated in the develop operation DEV based on a detection value of the wordline charging current Iwdc and at least one reference value. The bitline voltage control signal set may include the bitline shutoff control signal BLSHF and the bitline clamping control signal BLCLAMP. The wordline setup operation WLS, the pre-charge operation PRE, and the develop operation DEV are the same as described above, and thus redundant descriptions thereof are omitted. The number of the first to fourth current detection signals CDS1, CDS2, CDS3, and CDS4 is an example and may be more or less according to some example embodiments. When the first to fourth current detection signals CDS1, CDS2, CDS3, and CDS4 are deactivated during the wordline setup operation WLS, the smallest first current I1 among the first to fifth currents I1, I2, I3, I4, and I5 may be detected, and an erase-to-program ratio may be 0:100 (%).

In some example embodiments, the page buffer unit controller 2022 may increase an activation level of at least one of the bitline shutoff control signal BLSHF and the bitline clamping control signal BLCLAMP. Referring to FIG. 13A, for example, in order to increase a voltage level vBL of a bitline higher than a specific level va3, the activation level of the bitline clamping control signal BLCLAMP may be higher than a specific level va2, and the activation level of the bitline shutoff control signal BLSHF may be higher than a specific level va1. In some example embodiments different from that shown in FIG. 13A, only the activation level of the bitline shutoff control signal BLSHF or the activation level of the bitline clamping control signal BLCLAMP may increase. According to some example embodiments, the activation level of the bitline shutoff control signal BLSHF and/or the activation level of the bitline clamping control signal BLCLAMP may be determined through the first table TBL1 as shown in [Table 1] described above, and the page buffer unit controller 2022 may select "V1'" and/or "V1"" mapped to "N/A" in [Table 1] above.

In some example embodiments, the page buffer unit controller 2022 may increase an activation period of the bitline connection control signal CLBLK. Referring to FIG. 13B, for example, the activation period of the bitline connection control signal CLBLK may increase from a first period tDEV1 to a second period tDEV2. When the activation period of the bitline connection control signal CLBLK increases from the first period tDEV1 to the second period tDEV2, a time at which the activated bitline connection control signal CLBLK is deactivated may be delayed. The activation period of the bitline connection control signal CLBLK according to some example embodiments may be determined through the second table TBL2 as shown in [Table 2] described above, and the page buffer unit controller 2022 may select "t1" mapped to "N/A" in [Table 2].

In some example embodiments, the page buffer unit controller 2022 may adjust the activation level of the bitline shutoff control signal BLSHF, the activation level of the bitline clamping control signal BLCLAMP, and the activation period of the bitline connection control signal CLBLK. Referring to FIG. 13C, for example, in order to increase the voltage level vBL of the bitline, the activation level of the bitline clamping control signal BLCLAMP and the activation level of the bitline shutoff control signal BLSHF may increase, and the activation period of the bitline connection control signal CLBLK may increase from the first period tDEV1 to the second period tDEV2. The activation level of the bitline clamping control signal BLCLAMP, the activation level of the bitline shutoff control signal BLSHF, and the activation period of the bitline connection control signal CLBLK according to some example embodiments may be determined through the third table TBL3 as shown in [Table 3] described above, and the page buffer unit controller 2022 may select "V12''', "V12"", and "t12" mapped to "N/A" in [Table 3].

In some example embodiments, the smaller the detection value of the wordline charging current Iwdc, the higher the activation level of the bitline shutoff control signal BLSHF and/or the bitline clamping control signal BLCLAMP, and the longer the activation period of the bitline connection control signal CLBLK. For example, because a detection value of the first current I1 is less than a value of the first reference current Iref1, the activation level of the bitline shutoff control signal BLSHF and/or the bitline clamping control signal BLCLAMP and/or the activation period of the bitline connection control signal CLBLK may increase.

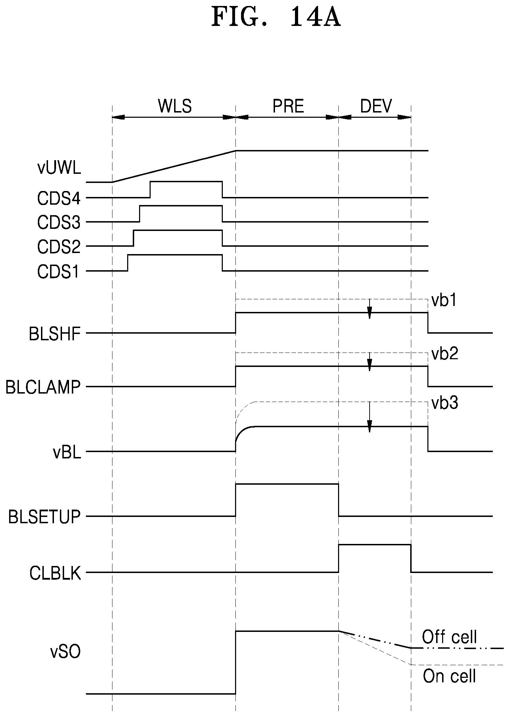

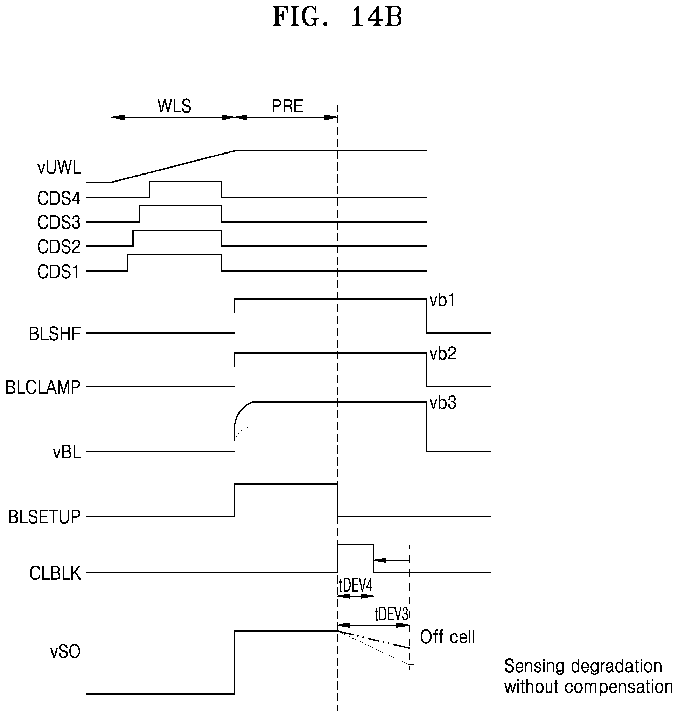

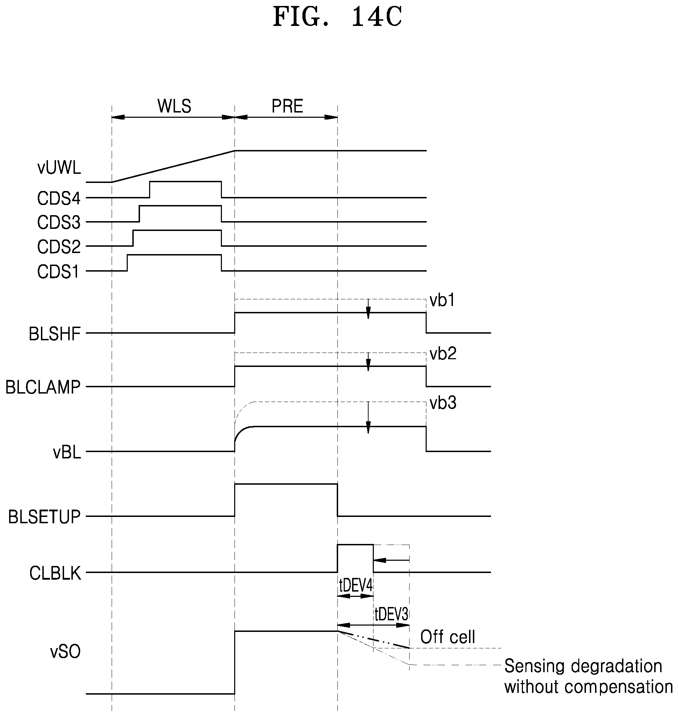

FIGS. 14A, 14B, and 14C are timing diagrams of control signals when the fifth current I5 of FIG. 12E is detected. Descriptions redundant with those of FIG. 13A, FIG. 13B, and FIG. 13C are omitted.

Referring to FIGS. 14A, 14B, and 14C, in some example embodiments, in order to compensate for the cell current Icc (or a difference between cell currents), the page buffer unit controller 2022 may adjust at least one of an activation level of a bitline voltage control signal set (e.g., BLSHF/BLCLAMP) and an activation period of the bitline connection control signal CLBLK based on a detection value of the wordline charging current Iwdc and at least one reference value. When the first to fourth current detection signals CDS1, CDS2, CDS3, and CDS4 are all activated during the wordline setup operation WLS, the largest fifth current I5 among the first to fifth currents I1, I2, I3, I4, and I5 may be detected, and an erase-to-program ratio may be 100:0 (%).

In some example embodiments, the page buffer unit controller 2022 may reduce an activation level of at least one of the bitline shutoff control signal BLSHF and the bitline clamping control signal BLCLAMP. Referring toFIGS. 14A, for example, in order to lower a voltage level vBL of a bitline below a specific level vb3, the activation level of the bitline clamping control signal BLCLAMP may be reduced below a specific level vb2, and the activation level of the bitline shutoff control signal BLSHF may be reduced below a specific level vb1. In some example embodiments different from that shown in FIGS. 14A, only the activation level of the bitline shutoff control signal BLSHF or the activation level of the bitline clamping control signal BLCLAMP may be reduced. The activation level of the bitline shutoff control signal BLSHF and/or the activation level of the bitline clamping control signal BLCLAMP according to some example embodiments may be determined through the first table TBL1 as shown in [Table 1] described above, and the page buffer unit controller 2022 may select "V11'" and/or "V11"" mapped to "CDSa to CDSj" in [Table 1].

In some example embodiments, the page buffer unit controller 2022 may reduce an activation period of the bitline connection control signal CLBLK. Referring to FIG. 14B, for example, the activation period of the bitline connection control signal CLBLK may decrease from a third period tDEV3 to a fourth period tDEV4. When the activation period of the bitline connection control signal CLBLK decreases from the third period tDEV3 to the fourth period tDEV4, at time at which the activated bitline connection control signal CLBLK is deactivated may be accelerated (e.g., advanced). The page buffer unit controller 2022 may select "t11" mapped to "CDSa to CDSj" in [Table 2] as the activation period of the bitline connection control signal CLBLK.

In some example embodiments, the activation level of the bitline shutoff control signal BLSHF, the activation level of the bitline clamping control signal BLCLAMP, and the activation period of the bitline connection control signal CLBLK may be reduced as shown in FIG. 14C. The page buffer unit controller 2022 may select "V22'", "V22"", and "t22" mapped to "CDSa to CDSj" in [Table 3].

In some example embodiments, as the detection value of the wordline charging current Iwdc increases, the activation level of the bitline shutoff control signal BLSHF and/or the bitline clamping control signal BLCLAMP and/or the activation period of the bitline connection control signal CLBLK may decrease. For example, because a detection value of the fifth current I5 is greater than value of each of the first to fourth reference currents Iref1, Iref2, Iref3, and Iref4, the activation level of the bitline shutoff control signal BLSHF and/or the bitline clamping control signal BLCLAMP and/or the activation period of the bitline connection control signal CLBLK may decrease.

Although not shown, when the wordline charging current Iwdc corresponding to an erase-to-program ratio included in a range between 0:100 (%) and 100:0 (%) is detected, similar to the example embodiments as shown in FIGS. 13A to 14C, the activation level of the bitline shutoff control signal BLSHF, the activation level of the bitline clamping control signal BLCLAMP, and/or the activation period of the bitline connection control signal CLBLK may be adjusted. For example, when the wordline charging current Iwdc is detected, the activation level of the bitline shutoff control signal BLSHF, the activation level of the bitline clamping control signal BLCLAMP, and/or the activation period of the bitline connection control signal CLBLK may be determined according to the first to third tables TBL1, TBL2, and TBL3 and activated current detection signals according to [Table 1] to [Table 3] described above.

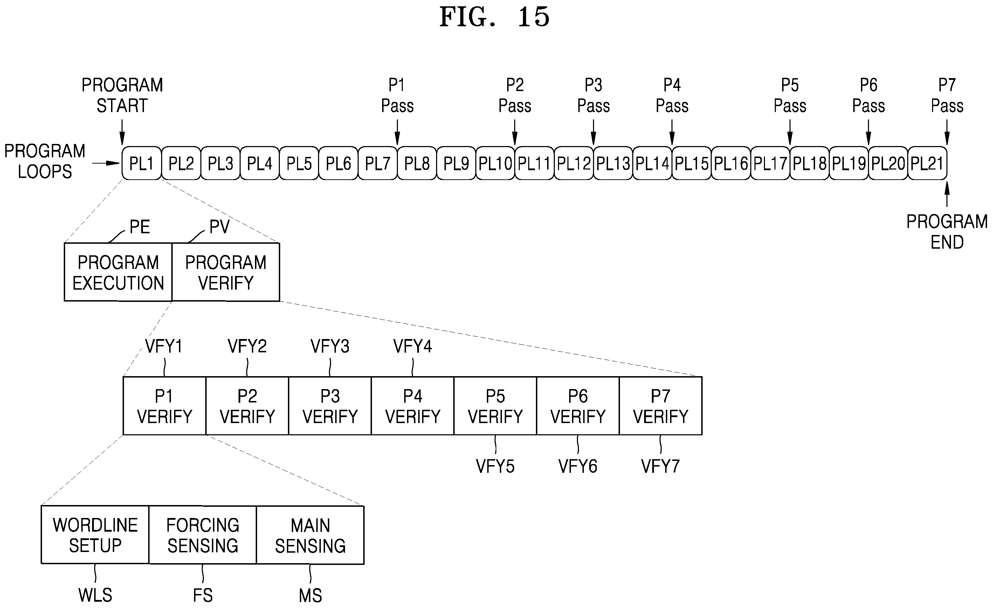

FIG. 15 is a diagram illustrating a plurality of program loops PL1 to PL21 according to some example embodiments.

Referring to FIG. 15, a program operation may include the plurality of program loops PL1 to PL21. The number of program loops may be determined in various ways according to some example embodiments. Each of the plurality of program loops PL1 to PL21 may include a program execution operation PE and at least one program verify operation PV. For example, when a memory cell is a triple level cell, the memory cell may be programmed to one of the first program state P1 to a seventh program state P7. In this case, the at least one program verify operation PV may include at least one of a first program verify operation VFY1 verifying the first program state P1, a second program verify operation VFY2 verifying the second program state P2, a third program verify operation VFY3 verifying the third program state P3, a fourth program verify operation VFY4 verifying the fourth program state P4, a fifth program verify operation VFY5 verifying the fifth program state P5, a sixth program verify operation VFY6 verifying the sixth program state P6, and a seventh program verify operation VFY7 verifying the seventh program state P7. However, the example embodiments are not limited to the above-described example. According to some example embodiments, the program verify operation PV with respect to a single level cell may include the first program verify operation VFY1, and the program verify operation PV with respect to a multilevel cell may include the first to third program verify operations VFY1, VFY2, and VFY3.

Each of the first to seventh program verify operations VFY1 to VFY7 may include the wordline setup operation WLS, a forcing sensing operation FS, and a main sensing operation MS. The forcing sensing operation FS refers to an operation of performing forcing sensing or pre-verify. The main sensing operation MS refers to an operation of performing main sensing or main verify. Unlike what shown in FIG. 15, in other embodiments, each of the first to seventh program verify operations VFY1 to VFY7 may include the wordline setup operation WLS and the main sensing operation MS.

As the program loop progresses, memory cells may gradually become program pass. The program pass means that memory cells enter a target threshold voltage region. For example, memory cells targeting the first program state P1 having the lowest target threshold voltage may all be program pass in the seventh program loop PL7. After the seventh program state P7 having the highest target threshold voltage is program pass, the program operation finally ends.

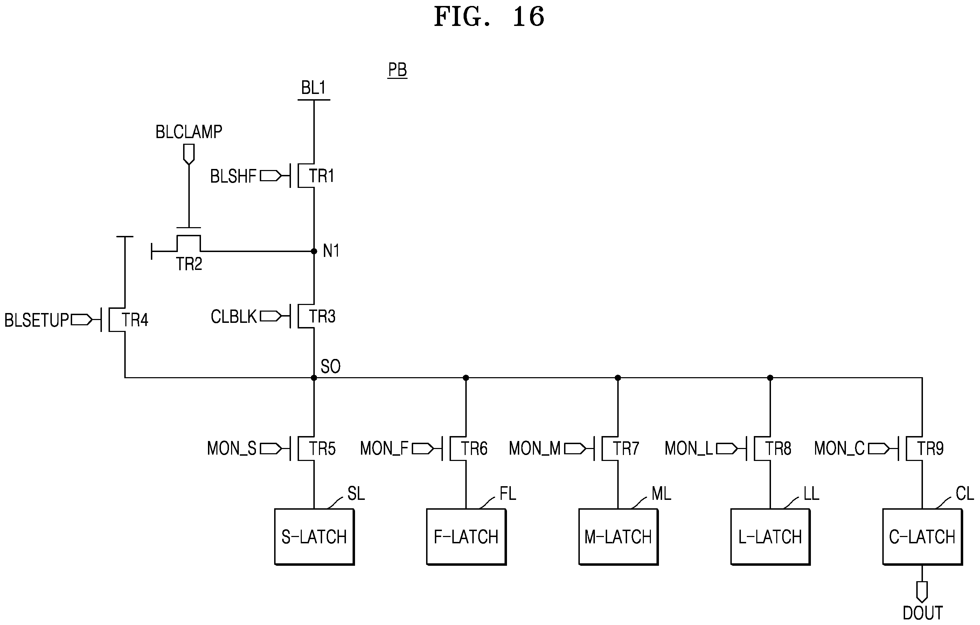

FIG. 16 is a diagram illustrating the page buffer PB according to some example embodiments.

Referring to FIG. 16, the page buffer PB may be included in the page buffer units 122 and 2050 of FIGS. 1 and 2. The page buffer PB may be connected to an arbitrary bitline (e.g., the first bitline BL1). The page buffer PB may include the first to ninth transistors TR1 to TR9, the sense latch SL, a force latch (F- latch) FL, an upper bit latch (M- latch) ML, a lower bit latch (L- latch) LL, and a cache latch (C- latch) CL. The first to fifth transistors TR1, TR2, TR3, TR4, and TR5 and the sense latch SL are the same as described above with reference to FIG. 10, and thus, redundant descriptions thereof are omitted.

The sixth transistor TR6 may be connected between the sensing node SO and the force latch FL, and may be driven by a forcing monitoring control signal MON_F. The force latch FL may be utilized to improve a threshold voltage distribution during a program operation. A value stored in the force latch FL may varies according to a threshold voltage of a memory cell during the program operation, and a voltage applied to the first bitline BL1 may vary according to the value stored in the force latch FL during program execution. When the sixth transistor TR6 is turned on by the forcing monitoring control signal MON_F, the force latch FL may be utilized to improve the threshold voltage distribution during the program operation. Specifically, for example, the force latch FL may store force data. The force data may be initially set to "1" and then may be inverted to "0" when a threshold voltage of the memory cell enters a forcing region that does not reach a target region. The force latch FL may control a bitline voltage during the program execution operation PE by utilizing the force data and may form a narrower threshold voltage distribution.

The seventh transistor TR7 may be connected between the sensing node SO and the upper bit latch ML, and may be driven by an upper bit monitoring control signal MON_M. The eighth transistor TR8 may be connected between the sensing node SO and the lower bit latch LL, and may be driven by a lower bit monitoring control signal MON_L. When the seventh and eighth transistors TR7 and TR8 are turned on by the upper bit monitoring control signal MON_M and the lower bit monitoring control signal MON_L, the upper bit latch ML and the lower bit latch LL in which target data is stored may be set according to sensed data stored in the sense latch SL. When the sensed data indicates that programming is completed, the upper bit latch ML and the lower bit latch LL may be switched to a program prohibition setting with respect to a selected memory cell in a subsequent program loop.

The ninth transistor TR9 may be connected between the sensing node SO and the cache latch CL, and may be driven by a caching monitoring control signal MON_C. When the ninth transistor TR9 is turned on by the cache monitoring control signal MON_C, the cache latch CL may receive data read from the memory cell from the sense latch SL during a read operation and output the data to the outside through a data output line DOUT. In addition, the cache latch CL may temporarily store input data provided from the outside. During the program operation, target data stored in the cache latch CL may be stored in the upper bit latch ML and the lower bit latch LL.

The upper bit latch ML, the lower bit latch LL, and the cache latch CL may be utilized to store data input from the outside during the program operation, and may be referred to as data latches. When 3-bit data is programmed in one memory cell, the 3-bit data may be stored in each of the upper bit latch ML, the lower bit latch LL, and the cache latch CL. The upper bit latch ML, the lower bit latch LL, and the cache latch CL may maintain stored data until the program of the memory cell is completed.

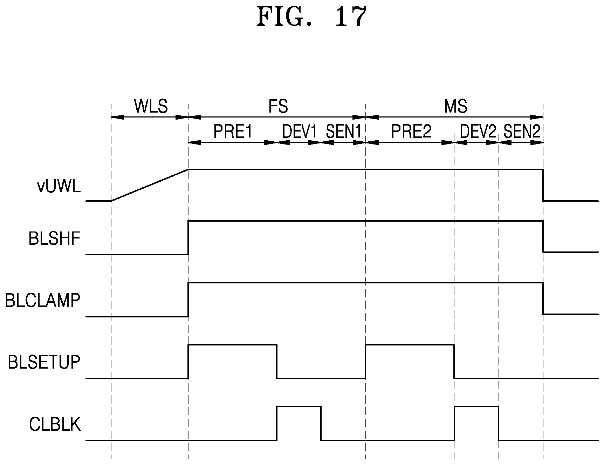

FIG. 17 is a timing diagram of signals provided to the page buffer PB of FIG. 16.

Referring to FIG. 17, the wordline setup operation WLS and the main sensing operation MS shown in FIG. 17 may be included in the program verify operation PV described above. For example, the wordline setup operation WLS and the main sensing operation MS may be included in each of the first to seventh program verify operations VFY1 to VFY7.

The wordline setup operation WLS is the same as described above with reference to FIGS. 11 to 12E. In some example embodiments, the wordline charging current Iwdc may be detected during a period in which the wordline setup operation WLS is performed, and the current detector 2021 may activate or deactivate the at least one current detection signal CDS based on a detection value of the wordline charging current Iwdc and at least one reference value.

The forcing sensing operation FS may include a first pre-charge operation PRE1, a first develop operation DEV1, and a first sensing operation SEN1. The main sensing operation MS may include a second pre-charge operation PRE2, a second develop operation DEV2, and a second sensing operation SEN2.

The bitline shutoff control signal BLSHF and the bitline clamping control signal BLCLAMP may be activated at a time at which the wordline setup operation WLS is completed. The bitline shutoff control signal BLSHF and the bitline clamping control signal BLCLAMP may be deactivated at a time at which the main sensing operation MS is completed (e.g., at a time at which the second sensing operation SEN2 is completed). In some example embodiments, as described above, an activation level of the bitline shutoff control signal BLSHF and/or an activation level of the bitline clamping control signal BLCLAMP may be adjusted according to the wordline charging current Iwdc.

The bitline setup control signal BLSETUP may be activated during a period in which each of the first pre-charge operation PRE1 and the second pre-charge operation PRE2 is performed.

The bitline connection control signal CLBLK may be activated during a period in which each of the first develop operation DEV1 and the second develop operation DEV2 is performed. In some example embodiments, as described above, the activation period of the bitline connection control signal CLBLK (e.g., when the activated bitline connection control signal CLBLK is deactivated) may be adjusted according to the wordline charging current Iwdc. For example, a first activation period in which the bitline connection control signal CLBLK is activated may be adjusted during a period in which the first develop operation DEV1 is performed. In addition, a second activation period in which the bitline connection control signal CLBLK is activated may be adjusted during a period in which the second develop operation DEV2 is performed.

During the period in which each of the first sensing operation SEN1 and the second sensing operation SEN2 is performed, the sensing monitoring control signal MON_S, the forcing monitoring control signal MON_F, the upper bit monitoring control signal MON_M, the lower bit monitoring control signal MON_L, and/or the caching monitoring control signal MON_C may be activated. When the period in which the first develop operation DEV1 is performed is changed, a start time of the first sensing operation SEN1 may also be changed. In addition, when the period in which the second develop operation DEV2 is performed is changed, a start time of the second sensing operation SEN2 may also be changed.

In some example embodiments, the activation level of the bitline shutoff control signal BLSHF, the activation level of the bitline clamping control signal BLCLAMP, and/or the activation period of the bitline connection control signal CLBLK may be determined based on a table, and the table may be configured as shown in [Table 4] below.

**[Table 4]**

| | | | | | | | |
|---|---|---|---|---|---|---|---|
| ERS:PGM ratio | 0:100 | 10:90 | 20:80 | ... | 80:20 | 90:10 | 100:0 |
| 1st SO Discharge Time | t_vfy1 | t_vfy2 | t_vfy3 | ... | t_vfy9 | t_vfy10 | t_vfy11 |
| 2nd SO Discharge Time | t_vfy1' | t_vfy2' | t_vfy3' | ... | t_vfy9' | t_vfy10' | t_vfy11' |
| Bitline Pre-charge Level | V_vfy1 | V_vfy2 | V_vfy3 | ... | V_vfy9 | V_vfy10 | V_vfy11 |

In [Table 4], "1st SO Discharge Time" means a first activation period of the bitline connection control signal CLBLK in the first develop operation DEV1. "2nd SO Discharge Time" means a second activation period of the bitline connection control signal CLBLK in the second develop operation DEV2. In table [4], "Bitline Pre-charge Level" may be used to determine an activation level of the bitline shutoff control signal BLSHF and/or an activation level of the bitline clamping control signal BLCLAMP. "t_vfy1" to "V_vfy11" for compensating the cell current Icc are not uniformly determined, and may be optimized in various ways according to some example embodiments.

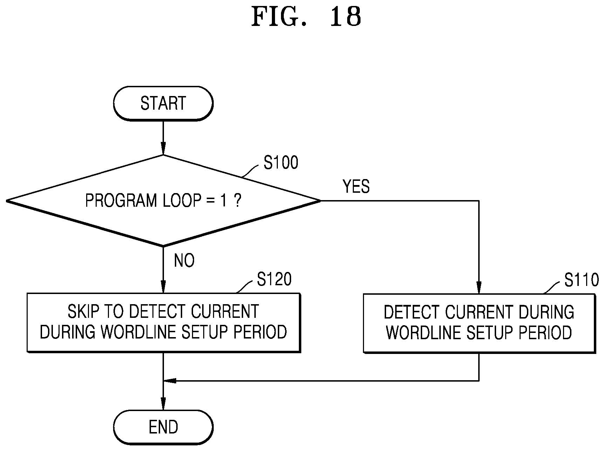

FIG. 18 is a flowchart for describing an operation of detecting the wordline charging current Iwdc in a program loop according to some example embodiments.

Referring to FIG. 18, in operation S100, the control logic circuit 2020 may confirm whether a current number of the program loop is 1. When the current number of the program loop is 1 (S100, YES), in operation S110, the control logic circuit 2020 may detect a current during a wordline setup period (e.g., the detection time Td of the wordline setup operation WLS). After the wordline setup operation WLS of the first program loop PL1 starts, for the certain detection time Td, an operation of detecting the wordline charging current Iwdc may be performed, and a detection value of the wordline charging current Iwdc may be stored in the control logic circuit 2020. When the current number of the program loop is 2 or more (S100, NO), in operation S120, the control logic circuit 2020 may skip to detect the current during the wordline setup period (e.g., the detection time Td of the wordline setup operation WLS). Because the adjustment value AJV with respect to the wordline charging current Iwdc detected in the first program loop PL1 is stored in the control logic circuit 2020, the wordline charging current Iwdc may not be detected in the program loops after the first program loop PL1.

In some example embodiments, the control logic circuit 2020 may detect the wordline charging current Iwdc in an initial program loop (e.g., the first program loop PL1 of FIG. 15). In addition, the control logic circuit 2020 may store a control amount (e.g., the adjustment value AJV of FIG. 9 including at least one activation level and/or an activation period) for adjusting at least one of the bitline voltage control signal set (e.g., BLSHF/BLCLAMP) and the bitline connection control signal CLBLK. In addition, the control logic circuit 2020 may skip an operation of detecting the wordline charging current Iwdc in each of the program loops after the initial program loop and adjust at least one of the bitline voltage control signal set and bitline connection control signal CLBLK according to the stored control amount (e.g., the adjustment value AJV stored in the buffer 2023 of FIG. 9).

According to the above-described embodiments, a process of detecting the wordline charging current Iwdc is skipped, thereby reducing computational throughput that may be redundant, reducing power consumption due to a reduction in the computational throughput, and/or improving the reliability of data.

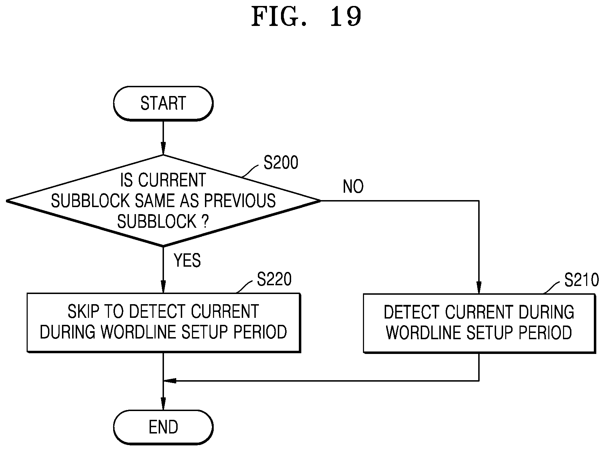

FIG. 19 is a flowchart for describing an operation of detecting the wordline charging current Iwdc according to some example embodiments.

Referring to FIG. 19, in operation S200, the control logic circuit 2020 may determine whether a sub-block (hereinafter referred to as "current sub-block") that is an object of an operation to be currently performed (e.g., a read operation or a program operation) is the same as a sub-block (hereinafter referred to as "previous sub-block") that is an object of a previous operation (e.g., the read operation or the program operation). When the current sub-block is different from the previous sub-block (S200, NO), in operation S210, the control logic circuit 2020 may detect a current during a wordline setup period during the operation to be currently performed. When the current sub-block is the same as the previous sub-block (S200, YES), an adjustment value AJV with respect to the wordline charging current Iwdc detected in the previously performed operation is stored in the control logic circuit 2020. Therefore, in operation S220, the control logic circuit 2020 may skip the operation of detecting the wordline charging current Iwdc during the operation to be currently performed.

In some example embodiments, the control logic circuit 2020 may perform a first read operation based on a first address and a first read command. The first address may correspond to a specific target wordline, and the specific target wordline may be included in any one sub-block. For example, the first address may correspond to a first target wordline included in the first sub-block SB1. However, the example embodiments are not limited to the above-described example. During the first read operation, the control logic circuit 2020 may store a first adjustment value. The control logic circuit 2020 may receive a second read command and a second address after the first read operation is completed. The control logic circuit 2020 may skip the operation of detecting the wordline charging current Iwdc in the second read operation according to the second read command and adjust at least one control signal (e.g., BLSHF, BLCLAMP, and/or CLBLK) according to the first adjustment value, based on whether a second target wordline corresponding to the second address is included in the first sub-block SB1.

In some example embodiments, the control logic circuit 2020 may perform a first program operation based on the first address and a first write command. It is assumed that an example of the first address corresponds to the first sub-block SB1 in the same manner as described above. The first program operation may include at least one program loop (e.g., the plurality of program loops PL1 to PL21 of FIG. 15). During the first program operation, the control logic circuit 2020 may store the first adjustment value. The control logic circuit 2020 may receive a second write command and a second address after the first program operation is completed. The control logic circuit 2020 may skip the operation of detecting the wordline charging current Iwdc in the second program operation according to the second write command and adjust at least one control signal according to the first adjustment value, based on whether the second target wordline corresponding to the second address is included in the first sub-block SB1.

According to the above-described embodiments, a process of detecting the wordline charging current Iwdc is skipped, thereby reducing computational throughput that may be redundant, reducing power consumption due to a reduction in the computational throughput, and/or improving the reliability of data.

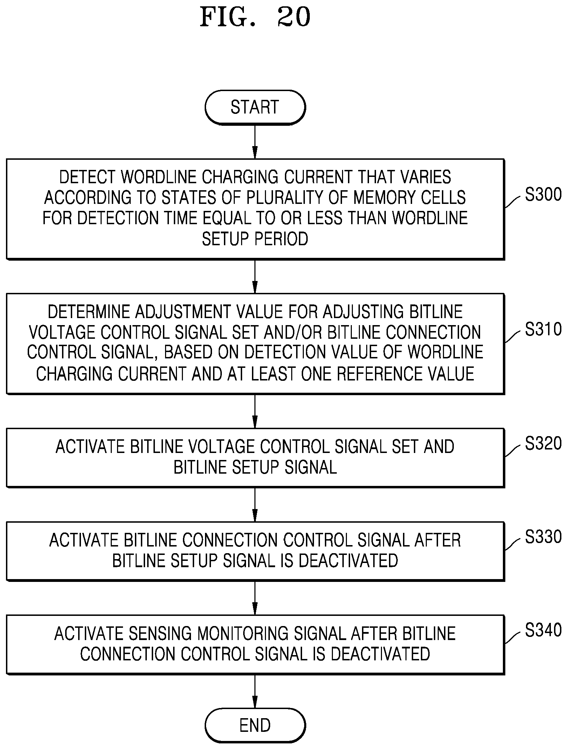

FIG. 20 is a flowchart illustrating an operating method of a non-volatile memory device according to some example embodiments.

Referring to FIG. 20, operation S300 of detecting a wordline charging current that varies according to states of a plurality of memory cells for a detection time equal to or substantially equal to or less than a wordline setup period is performed. The wordline setup period is a period in which a wordline setup operation is performed, and may be a period in which voltage levels of a plurality of wordlines increase to voltage levels of a plurality of wordline voltages. Example embodiments of operation S300 are as described above with reference to FIGS. 12A to 12E.

Operation S310 of determining an adjustment value for adjusting at least one of a bitline voltage control signal set and a bitline connection control signal applied to a plurality of bitlines based on a detection value of the wordline charging current and at least one reference value (for example, based on a result of comparison between detection value of the wordline charging current and at least one reference value) is performed. Example embodiments of operation S310 are as described above with reference to FIGS. 13A to 14C.

Operation S320 of activating the bitline voltage control signal set and a bitline setup signal is performed. Operation S320 may correspond to some example embodiments when the pre-charge operation PRE starts.

Operation S330 of activating the bitline connection control signal is performed after the bitline setup signal is deactivated. Operation S330 may correspond to some example embodiments when the develop operation DEV starts.

Operation S340 of activating at least one monitoring signal is performed after the bitline connection control signal is deactivated. Operation S340 may correspond to some example embodiments when the sensing operation SEN starts.

In some example embodiments, the bitline voltage control signal set may include a bitline shutoff control signal and a bitline clamping control signal. In this regard, the adjustment value may be a value for changing an activation level at which at least one of the bitline shutoff control signal and the bitline clamping control signal is activated. The adjustment value according to some example embodiments may be the same as in [Table 1] described above.

In some example embodiments, the adjustment value may be a value for changing an activation period in which the bitline connection control signal is activated. The adjustment value according to some example embodiments may be the same as in [Table 2] described above.

In some example embodiments, the at least one reference value may include a plurality of reference values having different magnitudes. Operation S310 may include determining the largest first adjustment value in response to a first detection value, as the detection value of the wordline charging current, less than the minimum reference value of a plurality of reference values, determining a second adjustment value less than the first adjustment value and decreasing as a second detection value increases in response to the second detection value, as the detection value of the wordline charging current, included in a range from the maximum reference value to the minimum reference value of the plurality of reference values, and determining the smallest third adjustment value in response to a third detection value, as the detection value of the wordline charging current, greater than the maximum reference value. Example embodiments of operation S310 are the same as described above with reference to FIGS. 9 and 12A to 14C.

In some example embodiments, the wordline charging current may be generated based on at least one of an external supply voltage supplied to the non-volatile memory device, an internal supply voltage of a voltage generator included in the non-volatile memory device, and a plurality of wordline voltages. The wordline charging current according to some example embodiments is the same as described above with reference to FIGS. 8A to 8D.

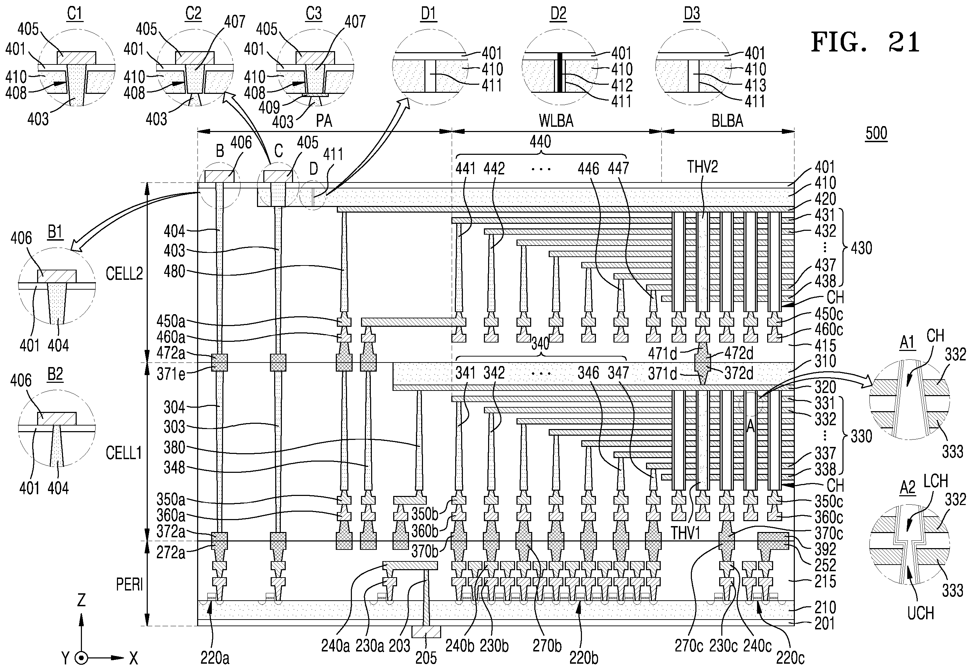

FIG. 21 is a cross-sectional view illustrating a non-volatile memory device 500 according to some example embodiments.

Referring to FIG. 21, the non-volatile memory device 500 may have a chip-to-chip (C2C) structure. The non-volatile memory device 500 may include at least one upper chip including a cell region. For example, the non-volatile memory device 500 may be implemented to include two upper chips. However, the number of the upper chips is not limited thereto. In the case in which the non-volatile memory device 500 implemented to include the two upper chips, the non-volatile memory device 500 may be manufactured by separately manufacturing a first upper chip including a first cell region CELL1, a second upper chip including a second cell region CELL2, and a lower chip including a peripheral circuit region PERI, and then, connecting the first upper chip, the second upper chip and the lower chip to each other by a bonding method. For example, the bonding method may mean a method of electrically or physically connecting a bonding metal pattern formed in the uppermost metal layer of the upper chip to a bonding metal pattern formed in the uppermost metal layer of the lower chip. The first upper chip may be turned over and may be connected to the lower chip by the bonding method, and the second upper chip may also be turned over and may be connected to the first upper chip by the bonding method. Hereinafter, an upper portion and a lower portion of each of the first upper chip and second upper chip are defined with respect to before the first upper chip and second upper chip are turned over. In other words, an upper portion of the lower chip may mean an upper portion defined with respect to a +Z-axis direction, and the upper portion of each of the first upper chip and second upper chip may mean an upper portion defined with respect to a -Z-axis direction in FIG. 21. However, in some example embodiments one of the first upper chip and the second upper chip may be turned over and may be connected to a corresponding chip by the bonding method.

Each of the peripheral circuit region PERI and the first cell region CELL1 and the second cell region CELL2 of the non-volatile memory device 500 may include an external pad bonding region PA, a wordline bonding region WLBA, and a bitline bonding region BLBA.

The peripheral circuit region PERI may include a first substrate 210, an interlayer insulating layer 215, and a plurality of circuit elements 220a, 220b, and 220c formed on the first substrate 210. The interlayer insulating layer 215 may include one or more insulating layers on the plurality of circuit elements 220a, 220b, and 220c. A plurality of metal layers (e.g., first metal layers 230a, 230b, and 230c and second metal layers 240a, 240b, and 240c) connected to the plurality of circuit elements 220a, 220b, and 220c may be provided in the interlayer insulating layer 215. In some example embodiments, the first metal layers 230a, 230b, and 230c may include tungsten having a relatively high electrical resistivity, and the second metal layers 240a, 240b, and 240c may include copper having a relatively low electrical resistivity The first metal layers 230a, 230b, and 230c and the second metal layers 240a, 240b, and 240c are illustrated and described herein, but the example embodiments are not limited thereto, and one or more additional metal layers may further be formed on the second metal layers 240a, 240b and 240c.

The interlayer insulating layer 215 may be disposed on the first substrate 210 to cover the plurality of circuit elements 220a, 220b, and 220c, the first metal layers 230a, 230b, and 230c, and the second metal layers 240a, 240b, and 240c, and may include an insulating material such as silicon oxide, silicon nitride, etc. However, example embodiments are not limited thereto.

Each of the first cell region CELL1 and the second cell region CELL2 may include at least one memory block. The first cell region CELL1 may include a second substrate 310 and a common source line 320. Likewise, the second cell region CELL2 may include a third substrate 410 and a common source line 420, and a plurality of wordlines 430: 431 to 438 may be stacked on the third substrate 410 in a third direction (e.g., the Z-axis direction) perpendicular to a top surface of the third substrate 410. Each of the second substrate 310 and the third substrate 410 may include various materials and may be, for example, a silicon substrate, a silicon-germanium substrate, a germanium substrate, or a substrate having a monocrystalline epitaxial layer grown on a monocrystalline silicon substrate. However, example embodiments are not limited thereto. One or more channel structures CH may be formed in each of the first cell region CELL1 and the second cell region CELL2.

In some example embodiments, as shown in A1 of FIG. 21, the channel structure CH may be provided in the bitline bonding region BLBA. The channel structure CH may include a lower channel LCH and an upper channel UCH, which are connected to each other. For example, the channel structure CH may be formed by a process with respect to the lower channel LCH and a process with respect to the upper channel UCH. The lower channel LCH may extend in a direction perpendicular to the top surface of the second substrate 310 to penetrate the common source line 320 and lower wordlines 331 and 332. The lower channel LCH may include a data storage layer, a channel layer, and a filling insulation layer and may be connected to the upper channel UCH. The upper channel UCH may penetrate upper wordlines 333 to 338. The upper channel UCH may include a data storage layer, a channel layer, and a filling insulation layer, and the channel layer of the upper channel UCH may be electrically connected to a first metal layer 350c and a second metal layer 360c. As the length of a channel increases, due to the manufacturing processes, it may be difficult to form a channel having a uniform width. The non-volatile memory device 500 according to some example embodiments may include a channel having improved width uniformity due to the lower channel LCH and the upper channel UCH, which are formed sequentially.

In the case in which the channel structure CH includes the lower channel LCH and the upper channel UCH as shown in A2 of FIG. 21, a wordline located near to a boundary between the lower channel LCH and the upper channel UCH may be a dummy wordline. For example, the wordlines 332 and 333 adjacent to the boundary between the lower channel LCH and the upper channel UCH may be the dummy wordlines. In this case, data may not be stored in memory cells connected to the dummy wordline. Alternatively, the number of pages corresponding to the memory cells connected to the dummy wordline may be less than the number of pages corresponding to the memory cells connected to a general wordline. A level of a voltage applied to the dummy wordline may be different from a level of a voltage applied to the general wordline, thereby reducing an influence of a non-uniform channel width between the lower and upper channels LCH and UCH on an operation of the memory device.

Meanwhile, the number of the lower wordlines 331 and 332 penetrated by the lower channel LCH is less than the number of the upper wordlines 333 to 338 penetrated by the upper channel UCH in A2 of FIG. 21. However, example embodiments are not limited thereto. In another example, the number of the lower wordlines penetrated by the lower channel LCH may be equal to or substantially equal to or greater than the number of the upper wordlines penetrated by the upper channel UCH. In addition, a structure and connection relation of the channel structure CH disposed in the first cell region CELL1 described above may be equally applied to the channel structure CH disposed in the second cell region CELL2.

In the bitline bonding region BLBA, a first through electrode THV1 may be provided in the first cell region CELL1, and a second through electrode THV2 may be provided in the second cell region CELL2. The first through electrode THV1 may penetrate the common source line 320 and the plurality of wordlines 330. However, the first through electrode THV1 may further penetrate the second substrate 310. The first through electrode THV1 may include a conductive material. Alternatively, the first through electrode THV1 may include a conductive material surrounded by an insulating material. The second through electrode THV2 may have the same shape and structure as the first through electrode THV1.

In some example embodiments, the first through electrode THV1 and the second through electrode THV2 may be electrically connected to each other through a first through metal pattern 372d and a second through metal pattern 472d. The first through metal pattern 372d may be formed at a bottom end of the first upper chip including the first cell region CELL1, and the second through metal pattern 472d may be formed at a top end of the second upper chip including the second cell region CELL2. The first through electrode THV1 may be electrically connected to the first metal layer 350c and the second metal layer 360c. A lower via 371d may be formed between the first through electrode THV1 and the first through metal pattern 372d, and an upper via 471d may be formed between the second through electrode THV2 and the second through metal pattern 472d. For example, the second through electrode THV2 may be electrically connected to metal layers 450c and 460c. The first through metal pattern 372d and the second through metal pattern 472d may be connected to each other by the bonding method.

In addition, in the bitline bonding region BLBA, an upper metal pattern 252 may be formed in the uppermost metal layer of the peripheral circuit region PERI, and an upper metal pattern 392 may be formed in the uppermost metal layer of the first cell region CELL1. In the bitline bonding region BLBA, the bitline 360c may be electrically connected to a page buffer included in the peripheral circuit region PERI. For example, a portion of the circuit elements 220c of the peripheral circuit region PERI may provide the page buffer, and the bitline 360c may be electrically connected to the circuit elements 220c providing the page buffer through an upper bonding metal pattern 370c of the first cell region CELL1 and an upper bonding metal pattern 270c of the peripheral circuit region PERI.

In the wordline bonding region WLBA, the wordlines 330 of the first cell region CELL1 may extend in a second direction (e.g., an X-axis direction) parallel to the top surface of the second substrate 310 and may be connected to a plurality of cell contact plugs 340: 341 to 347. First metal layers 350b and second metal layers 360b may be sequentially connected onto the plurality of cell contact plugs 340 connected to the wordlines 330. In the wordline bonding region WLBA, the plurality of cell contact plugs 340 may be connected to the peripheral circuit region PERI through upper bonding metal 370b of the first cell region CELL1 and upper bonding metal 270b of the peripheral circuit region PERI.

The plurality of cell contact plugs 340 may be electrically connected to a row decoder included in the peripheral circuit region PERI. For example, a portion of the circuit elements 220b of the peripheral circuit region PERI may provide the row decoder, and the plurality of cell contact plugs 340 may be electrically connected to the circuit elements 220b providing the row decoder through the upper bonding metal 370b of the first cell region CELL1 and the upper bonding metal 270b of the peripheral circuit region PERI. In some example embodiments, an operating voltage of the circuit elements 220b providing the row decoder may be different from an operating voltage of the circuit elements 220c providing the page buffer.

In the wordline bonding region WLBA, the wordlines 430 of the second cell region CELL2 may extend in the second direction (e.g., the X-axis direction) parallel to the top surface of the third substrate 410 and may be connected to a plurality of cell contact plugs 440: 441 to 447. The cell contact plugs 440 may be connected to the peripheral circuit region PERI through an upper metal pattern of the second cell region CELL2, lower and upper metal patterns of the first cell region CELL1, and a cell contact plug 348.

In the wordline bonding region WLBA, the upper bonding metal 370b may be formed in the first cell region CELL1, and the upper bonding metal 270b may be formed in the peripheral circuit region PERI. The upper bonding metal 370b of the first cell region CELL1 and the upper bonding metal 270b of the peripheral circuit region PERI may be electrically connected to each other by the bonding method. The upper bonding metal 370b and the upper bonding metal 270b may include aluminum, copper, or tungsten.

In the external pad bonding region PA, a lower metal pattern 371e may be formed in a lower portion of the first cell region CELL1, and an upper metal pattern 472a may be formed in an upper portion of the second cell region CELL2. The lower metal pattern 371e of the first cell region CELL1 and the upper metal pattern 472a of the second cell region CELL2 may be connected to each other by the bonding method in the external pad bonding region PA. Likewise, an upper metal pattern 372a may be formed in an upper portion of the first cell region CELL1, and an upper metal pattern 272a may be formed in an upper portion of the peripheral circuit region PERI. The upper metal pattern 372a of the first cell region CELL1 and the upper metal pattern 272a of the peripheral circuit region PERI may be connected to each other by the bonding method.

Common source line contact plugs 380 and 480 may be disposed in the external pad bonding region PA. The common source line contact plugs 380 and 480 may include a metal, a metal compound, or a conductive material such as doped polysilicon. The common source line contact plug 380 of the first cell region CELL1 may be electrically connected to the common source line 320, and the common source line contact plug 480 of the second cell region CELL2 may be electrically connected to the common source line 420. A first metal layer 350a and a second metal layer 360a may be sequentially stacked on the common source line contact plug 380 of the first cell region CELL1, and a first metal layer 450a and a second metal layer 460a may be sequentially stacked on the common source line contact plug 480 of the second cell region CELL2.

First to third input/output pads 205, 405, and 406 may be disposed in the external pad bonding region PA. The first input/output pad 205 may be formed on a lower insulation layer 201 as described with reference to FIG. 21. The first input/output pad 205 may be connected to at least one of the plurality of circuit elements 220a through a first input/output contact plug 203. An upper insulating layer 401 covering a top surface of the third substrate 410 may be formed on the third substrate 410. The second input/output pad 405 and/or the third input/output pad 406 may be disposed on the upper insulating layer 401. The second input/output pad 405 may be connected to at least one of the plurality of circuit elements 220a through second input/output contact plugs 403 and 303, and the third input/output pad 406 may be connected to at least one of the plurality of circuit elements 220a through third input/output contact plugs 404 and 304.

In some example embodiments, the third substrate 410 may not be disposed in a region in which the input/output contact plug is disposed. For example, as shown in B of FIG. 21, the third input/output contact plug 404 may be separated from the third substrate 410 in a direction parallel to the top surface of the third substrate 410 and may be connected to the third input/output pad 406 through an interlayer insulating layer 415 of the second cell region CELL2. In this case, the third input/output contact plug 404 may be formed by various processes.

For example, as shown in B1 of FIG. 21, the third input/output contact plug 404 may extend in the third direction, and a diameter of the third input/output contact plug 404 may increase toward the upper insulating layer 401. In other words, a diameter of the channel structure CH described in A1 of FIG. 21 may decrease toward the upper insulating layer 401, whereas the diameter of the third input/output contact plug 404 may increase toward the upper insulating layer 401. For example, the third input/output contact plug 404 may be formed after the second cell region CELL2 and the first cell region CELL1 are connected to each other by the bonding method.

In addition, as shown in B2 of FIG. 21, the third input/output contact plug 404 may extend in the third direction, and the diameter of the third input/output contact plug 404 may decrease toward the upper insulating layer 401. In other words, like the channel structure CH, the diameter of the third input/output contact plug 404 may decrease toward the upper insulating layer 401. For example, the third input/output contact plug 404 may be formed together with the cell contact plugs 440 before the second cell region CELL2 and the first cell region CELL1 are connected to each other by the bonding method.

In another example embodiment, the input/output contact plug may overlap with the third substrate 410. For example, as shown in C of FIG. 21, the second input/output contact plug 403 may be formed through the interlayer insulating layer 415 of the second cell region CELL2 in the third direction (e.g., the Z-axis direction) and may be electrically connected to the second input/output pad 405 through the third substrate 410. In this case, a connection structure of the second input/output contact plug 403 and the second input/output pad 405 may be implemented by various methods.

For example, as shown in C1 of FIG. 21, an opening 408 may be formed through the third substrate 410, and the second input/output contact plug 403 may be directly connected to the second input/output pad 405 through the opening 408 formed in the third substrate 410. In this case, as shown in C1, a diameter of the second input/output contact plug 403 may increase toward the second input/output pad 405. However, the diameter of the second input/output contact plug 403 may decrease toward the second input/output pad 405.

For example, as shown in C2 of FIG. 21, the opening 408 may be formed through the third substrate 410, and a contact 407 may be formed in the opening 408. An end of the contact 407 may be connected to the second input/output pad 405, and another end of the contact 407 may be connected to the second input/output contact plug 403. Accordingly, the second input/output contact plug 403 may be electrically connected to the second input/output pad 405 through the contact 407 in the opening 408. In this case, as shown in C2 of FIG. 21, a diameter of the contact 407 may increase toward the second input/output pad 405, and the diameter of the second input/output contact plug 403 may decrease toward the second input/output pad 405. For example, the second input/output contact plug 403 may be formed together with the cell contact plugs 440 before the second cell region CELL2 and the first cell region CELL1 are connected to each other by the bonding method, and the contact 407 may be formed after the second cell region CELL2 and the first cell region CELL1 are connected to each other by the bonding method.

In addition, for example, as shown in C3 of FIG. 21, a stopper 409 may be further formed on a bottom surface of the opening 408 of the third substrate 410, as compared with C2 of FIG. 21. The stopper 409 may be a metal layer formed in the same layer as the common source line 420. However, the stopper 409 may be a metal layer formed in the same layer as at least one of the wordlines 430. The second input/output contact plug 403 may be electrically connected to the second input/output pad 405 through the contact 407 and the stopper 409. However, example embodiments are not limited thereto.

Similarly to the second input/output contact plug 403 and the third input/output contact plug 404 of the second cell region CELL2, a diameter of each of the second input/output contact plug 303 and the third input/output contact plug 304 of the first cell region CELL1 may decrease toward the lower metal pattern 371e or may increase toward the lower metal pattern 371e.

Meanwhile, in some example embodiments, a slit 411 may be formed in the third substrate 410. For example, the slit 411 may be formed at a certain position of the external pad bonding region PA. For example, as shown in D of FIG. 21, the slit 411 may be located between the second input/output pad 405 and the cell contact plugs 440 when viewed in a plan view. However, the slit 411 may be formed such that the second input/output pad 405 may be located between the slit 411 and the cell contact plugs 440 when viewed in a plan view.

For example, as shown in D1 of FIG. 21, the slit 411 may be formed through the third substrate 410. For example, the slit 411 may be used to reduce and/or prevent the third substrate 410 from being finely cracked when the opening 408 is formed. However, the slit 411 may be formed to have a depth ranging from about 60% to about 70 % of a thickness of the third substrate 410.

In addition, for example, as shown in D2 of FIG. 21, a conductive material 412 may be formed in the slit 411. For example, the conductive material 412 may be used to discharge a leakage current occurring in driving of the circuit elements in the external pad bonding region PA to the outside. In this case, the conductive material 412 may be connected to an external ground line.

In addition, for example, as shown in D3 of FIG. 21, an insulating material 413 may be formed in the slit 411. For example, the insulating material 413 may be used to electrically isolate the second input/output pad 405 and the second input/output contact plug 403 disposed in the external pad bonding region PA from the wordline bonding region WLBA. The insulating material 413 is formed in the slit 411, thereby limiting and/or preventing a voltage provided through the second input/output pad 405 from affecting a metal layer disposed on the third substrate 410 in the wordline bonding region WLBA.

Meanwhile, in some example embodiments, the first to third input/output pads 205, 405 and 406 may be selectively formed. For example, the non-volatile memory device 500 may be implemented to include only the first input/output pad 205 disposed on the first substrate 210, to include only the second input/output pad 405 disposed on the third substrate 410, or to include only the third input/output pad 406 disposed on the upper insulating layer 401.

Meanwhile, in some example embodiments, at least one of the second substrate 310 of the first cell region CELL1 and the third substrate 410 of the second cell region CELL2 may be used as a sacrificial substrate and may be completely or partially removed before or after a bonding process. An additional layer may be stacked after the removal of the substrate. For example, the second substrate 310 of the first cell region CELL1 may be removed before or after the bonding process of the peripheral circuit region PERI and the first cell region CELL1, and then, an insulating layer covering a top surface of the common source line 320 or a conductive layer for connection may be formed. Similarly, the third substrate 410 of the second cell region CELL2 may be removed before or after the bonding process of the first cell region CELL1 and the second cell region CELL2, and then, the upper insulating layer 401 covering a top surface of the common source line 420 or a conductive layer for connection may be formed.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

While some example embodiments of the inventive concepts have been particularly shown and described with reference to example embodiments thereof, it will be understood that various changes in form and details may be made therein without departing from the scope of the following claims.

## Claims

1. A non-volatile memory device (2000) comprising:
a memory cell array (2010) comprising a plurality of memory cells (MC) connected to a plurality of wordlines (WL) and a plurality of bitlines (BL);
a page buffer unit (2050) comprising page buffers (PB) connected to the plurality of memory cells (MC) through the plurality of bitlines (BL); and
a control logic circuit (2020) configured to
output at least one control signal to the page buffer unit (2050) for performing a read operation based on a read command (CMD) and an address (ADDR),
the read operation comprising
a wordline setup operation (WLS),
a pre-charge operation (PRE),
a develop operation (DEV), and
a sensing operation (SEN),
wherein the control logic circuit (2020) is configured to
detect a wordline charging current (Iwdc) that varies based on states of the plurality of memory cells (MC), during a preset detection time (Td) in the wordline setup operation (WLS), and
based on a detection value of the wordline charging current (Iwdc) and at least one reference value, adjust at least one of a bitline voltage control signal set (BLSHF, BLCLAMP) after the wordline setup operation (WLS) and a bitline connection control signal (CLBLK) during the develop operation (DEV).

2. The non-volatile memory device (2000) of claim 1, wherein
the bitline voltage control signal set (BLSHF, BLCLAMP) includes a bitline shutoff control signal (BLSHF) and a bitline clamping control signal (BLCLAMP), and
the control logic circuit (2020) is configured to adjust an activation level at which at least one of the bitline shutoff control signal (BLSHF) and the bitline clamping control signal (BLCLAMP) is activated.

3. The non-volatile memory device (2000) of claim 2, wherein
the control logic circuit (2020) is configured to
increase the activation level based on the detection value being less than a first reference value, and
decrease the activation level based on the detection value being greater than or equal to the first reference value.

4. The non-volatile memory device (2000) of any preceding claim, wherein the control logic circuit (2020) is configured to adjust an activation period in which the bitline connection control signal (CLBLK) is activated.

5. The non-volatile memory device (2000) of claim 4, wherein
the control logic circuit (2020) is configured to
increase the activation period based on the detection value being less than a first reference value, and
decrease the activation period based on the detection value being greater than or equal to the first reference value.

6. The non-volatile memory device (2000) of any preceding claim, wherein
the at least one reference value includes a plurality of reference values, and
the control logic circuit (2020) is configured to determine an adjustment value (AJV) for adjusting the at least one control signal based on a result of comparison between each of the plurality of reference values and the detection value.

7. The non-volatile memory device (2000) of any preceding claim, further comprising:
a voltage generator (2030) configured to
generate an internal supply voltage (Vcp) based on an external supply voltage (VEXT),
generate a read voltage and a read pass voltage based on the internal supply voltage (Vcp),
provide the read voltage to a selected wordline (WL) among the plurality of wordlines (WL), and
provide the read pass voltage to unselected wordlines (WL) among the plurality of wordlines (WL),
wherein the control logic circuit (2020) is configured to
provide a voltage control signal (CTRL_vol) instructing the voltage generator (2030) to generate the read voltage and the read pass voltage based on the read command (CMD) and the address (ADDR), and
detect the wordline charging current (Iwdc) based on at least one of the external supply voltage (VEXT), the internal supply voltage (Vcp), the read voltage, and the read pass voltage.

8. The non-volatile memory device (2000) of any preceding claim, wherein
the plurality of memory cells (MC) are included in a plurality of sub-blocks (SB1, SB2, SB3) in an erase operation unit,
each of the plurality of sub-blocks (SB1, SB2, SB3) includes a portion of the plurality of memory cells (MC) connected to a portion of the plurality of wordlines (WL), and
the control logic circuit (2020) is configured to perform a first read operation, based on a first address corresponding to a first target wordline (WL) included in a first sub-block (SB1) and a first read command.

9. The non-volatile memory device (2000) of claim 8, wherein
the control logic circuit (2020) is configured to
store a first adjustment value for adjusting the at least one control signal based on the first read operation being performed,
receive a second read command and a second address based on the first read operation completing, and
based on a second target wordline (WL) corresponding to the second address being included in the first sub-block (SB1), skip an operation of detecting the wordline charging current (Iwdc) in a second read operation based on the second read command and adjust the at least one control signal according to the first adjustment value.

10. An operating method of a non-volatile memory device (2000), the operating method comprising:
detecting a wordline charging current (Iwdc) related to a plurality of wordline voltages (VWL), during a detection time (Td) equal to or less than a wordline setup period based on voltage levels of a plurality of wordlines (WL) increasing to voltage levels of the plurality of wordline voltages (VWL);
determining an adjustment value (AJV) for adjusting at least one of a bitline voltage control signal set (BLSHF, BLCLAMP) and a bitline connection control signal (CLBLK) applied to a plurality of bitlines (BL) based on a detection value of the wordline charging current (Iwdc) and at least one reference value;
activating the bitline voltage control signal set (BLSHF, BLCLAMP) and a bitline setup signal (BLSETUP);
activating the bitline connection control signal (CLBLK) after the bitline setup signal (BLSETUP) is deactivated; and
activating at least one monitoring signal after the bitline connection control signal (CLBLK) is deactivated.

11. The operating method of claim 10, wherein
the bitline voltage control signal set (BLSHF, BLCLAMP) includes a bitline shutoff control signal (BLSHF) and a bitline clamping control signal (BLCLAMP), and
the adjustment value (AJV) is a value for changing an activation level at which at least one of the bitline shutoff control signal (BLSHF) and the bitline clamping control signal (BLCLAMP) is activated.

12. The operating method of claim 10 or claim 11, wherein the adjustment value (AJV) is a value for changing an activation period in which the bitline connection control signal (CLBLK) is activated.

13. The operating method of any of claims 10-12, wherein
the at least one reference value includes a plurality of reference values having different magnitudes from each other, and
the determining of the adjustment value (AJV) includes
determining a first adjustment value being largest, in response to a first detection value, as the detection value, being less than a minimum reference value of the plurality of reference values,
determining a second adjustment value being less than the first adjustment value and decreasing as a second detection value increases, in response to the second detection value included in a range from a maximum reference value of the plurality of reference values to the minimum reference value; and
determining a smallest third adjustment value, in response to a third detection value, as the detection value, being greater than the maximum reference value.

14. The operating method of any of claims 10-13, wherein the wordline charging current (Iwdc) is generated based on at least one of
an external supply voltage (VEXT) supplied to the non-volatile memory device (2000),
an internal supply voltage (Vcp) of a voltage generator (2030) included in the non-volatile memory device (2000), and
the plurality of wordline voltages (VWL).

15. The operating method of any of claims 10-14, wherein the adjustment value (AJV) is one of a first value for changing an activation level at which at least one of the bitline shutoff control signal (BLSHF) and the bitline clamping control signal (BLCLAMP) is activated, and a second value for changing an activation period in which the bitline connection control signal (CLBLK) is activated, and
wherein the activation level and activation period are increased, based on the detection value being less than a first reference value of the at least one reference value, and
wherein the activation level and activation period are decreased, based on the detection value being greater than or equal to the first reference value.
